# EUROPÄISCHE PATENTANMELDUNG

(11) **EP 0 899 790 A2**
(43) Veröffentlichungstag der Anmeldung: **03.03.1999**
(21) Anmeldenummer: 98115414.9
(22) Anmeldetag: 14.08.1998
(51) Int. Cl.: H01L 27/108, H01L 21/8242

(54) **DRAM-Zellanordnung und Verfahren zu deren Herstellung**

(30) Priorität: 27.08.1997 DE 19737386
(71) Anmelder: SIEMENS AKTIENGESELLSCHAFT, 80333 München (DE)
(72) Erfinder: Goebel, Bernd, 81735 München (DE); Bertagnolli, Emmerich, 80799 München (DE); Klose, Helmut, New York 12603 (US)

(57) **Zusammenfassung**

An einer von zwei sich gegenüberliegenden Flanken einer Halbleiterstruktur, die ein Source/Drain-Gebiet (S/D1a) und ein darunter angeordnetes Kanalgebiet (Kaa) eines vertikalen Auswahltransistors umfaßt und die zwischen Gräben angeordnet sein kann, ist in einer Höhe des Kanalgebiets (Kaa) ein Element angeordnet, das die Ausbildung eines Kanals verhindert. An beide Flanken grenzen das Source/Drain-Gebiet sowie je eine Wortleitung (Wla) an. Für folded Bitleitungen (Bla) können in den Gräben (G2a) jeweils zwei Wortleitungen (Wla) gebildet werden. Die Elemente von entlang eines der Gräben (G2a) benachbarten Halbleiterstrukturen sind dann alternierend an eine Flanke des Grabens (G2a) und an eine Flanke eines benachbarten der Gräben (G2a) angeordnet. Ein Speicherkondensator kann oberhalb eines Substrats (1a) angeordnet oder im Substrat (1a) vergraben sein. Die Verbindung des Auswahltransistors mit einer Bitleitung (Bla) kann auf vielfältige Art erfolgen.

## Beschreibung

In DRAM-Zellenanordnungen, d.h. Speicherzellen-Anordnungen mit dynamischem, wahlfreiem Zugriff, werden fast ausschließlich sog. Eintransistor-Speicherzellen eingesetzt. Eine Eintransistor-Speicherzelle umfaßt einen Auswahltransistor und einen Speicherkondensator. In dem Speicherkondensator ist die Information in Form einer elektrischen Ladung gespeichert, die eine logische Größe, 0 oder 1, darstellt. Durch Ansteuerung des Auswahltransistors über eine Wortleitung kann diese Information über eine Bitleitung ausgelesen werden.

Da von Speichergeneration zu Speichergeneration die Speicherdichte zunimmt, muß die benötigte Flache der Eintransistor-Speicherzelle von Generation zu Generation reduziert werden. Da der Reduktion der Strukturgrößen durch die minimale in der jeweiligen Technologie herstellbare Strukturgröße F Grenzen gesetzt sind, ist dies auch mit einer Veränderung der Eintransistor-Speicherzelle verbunden. So wurden bis zur 1MBit-Generation sowohl der Auswahltransistor als auch der Speicherkondensator als planare Bauelemente realisiert. Ab der 4MBit-Speichergeneration mußte eine weitere Flächenreduzierung durch eine dreidimensionale Abordnung von Auswahltransistor und Speicherkondensator erfolgen.

Eine Möglichkeit besteht darin, den Speicherkondensator nicht planar, sondern in einem Graben zu realisieren (siehe z.B. K. Yamada et al. 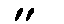 A deep trenched Capacitor technology for 4 MBit DRAMs", Proc. Intern. Electronic Devices and Materials IEDM 85, Seite 702).

Eine andere Möglichkeit besteht in der Verwendung vertikaler MOS-Transistoren wie z.B. in US-PS 5 376 575 beschrieben.

In der älteren deutschen Patentanmeldung 19620625.1 ist eine DRAM-Zellenanordnung beschrieben, deren Auswahltransistoren als vertikale MOS-Transistoren oberhalb von Speicherkondensatoren gebildet werden. Dazu werden erste Gräben und quer dazu zweite Gräben in einem Substrat erzeugt. Die Speicherkondensatoren sind jeweils in den Gräben angeordnet. Jeweils zwei der zweiten Gräben bilden ein Grabenpaar, das von einer Isolationsstruktur umgeben ist. Zwischen den zweiten Gräben jedes Grabenpaars ist eine Halbleiterinsel angeordnet. An einer ersten gemeinsamen Flanke der Halbleiterinsel und eines ersten der zwei zweiten Gräben ist ein erster Auswahltransistor mit einer ersten Gateelektrode angeordnet und an einer zweiten gemeinsamen Flanke der Halbleiterinsel und eines zweiten der zwei zweiten Gräben ist ein zweiter Transistor mit einer zweiten Gateelektrode angeordnet. Jeweils ein Speicherknoten der Speicherkondensatoren grenzt an eine der Flanken der Halbleiterinsel an. Zur Ermöglichung von folded Bitleitungen werden die Halbleiterinseln entlang benachbarter erster Gräben jeweils versetzt zueinander angeordnet. Bei folded Bitleitungen wird zum Auslesen der Information des Auswahltransistors, das Signal der zugehörigen Bitleitung mit dem Signal einer benachbarten Bitleitung verglichen. Die Wortleitung, über die der Auswahltransistor angesteuert wird, darf mit keinem Auswahltransistor, der mit der benachbarten Bitleitung verbunden ist, verbunden sein. Dadurch können Störungen und Signaluntergrund, welche auf den sehr dicht beieinanderliegenden Bitleitungen gleich sind, nahezu eliminiert werden. Dies ist vorteilhaft, da das Signal, welches an der Bitleitung ausgewertet werden muß, mit Reduktion der Strukturgröße immer kleiner wird.

In DE 195 191 60 C1 ist eine DRAM-Zellenanordnung beschrieben, die pro Speicherzelle einen vertikalen MOS-Transistor umfaßt, dessen erstes Source/Drain-Gebiet mit einem Speicherknoten eines Speicherkondensators verbunden ist, dessen Kanalgebiet ringförmig von einer Gateelektrode umschlossen wird und dessen zweites Source/Drain-Gebiet mit einer vergrabenen Bitleitung verbunden ist. Der Speicherkondensator ist entweder ein planarer Kondensator oder ein Stapelkondensator.

In US 4 630 088 ist eine DRAM-Zellenanordnung beschrieben, bei der ein Kondensator einer Speicherzelle zwischen einem Auswahltransistor der Speicherzelle und einer Bitleitung geschaltet ist. An jede von zwei sich gegenüberliegende Flanken einer streifenförmigen Halbleiterstruktur ist eine Wortleitung angeordnet. Die Halbleiterstruktur umfaßt ein oberes und ein unters Source/Drain-Gebiet des Auswahltransistors. Zwischen den Source/Drain-Gebieten ist ein Kanalgebiet angeordnet. Das obere Source/Drain-Gebiet grenzt an eine der zwei Flanken an. Neben dem oberen Source/Drain-Gebiet ist ein dotiertes Gebiet angeordnet, das vom selben Leitfähigkeitstyp wie der des Kanalgebiets dotiert ist, aber eine höhere Dotierstoffkonzentration aufweist. Das dotierte Gebiet bewirkt, das der Auslesetransistor nur von der Wortleitung angesteuert wird, der an der Flanke der Halbleiterstruktur angeordnet ist, an die das obere Source/Drain-Gebiet angrenzt.

In US 5 214 603 wird eine DRAM-Zellenanordnung beschrieben, bei der ein Auswahltransistor einer Speicherzelle zwischen einem Kondensator der Speicherzelle und einer Bitleitung geschaltet ist. An Flanken von parallel zueinander verlaufenden Gräben sind Wortleitungen angeordnet. Eine Halbleiterstruktur ist zwischen zwei der Gräben angeordnet und umfaßt ein für zwei Auswahltransistoren gemeinsames Source/Drain-Gebiet und zwei untere Source/Drain-Gebiete der Auswahltransistoren. Zwischen dem oberen und den unteren Source/Drain-Gebieten ist ein dotiertes Gebiet angeordnet, das von einem Leitfähigkeitstyp dotiert ist, der entgegengesetzt zu einem Leitfähigkeitstyp der Source/Drain-Gebiete ist. Zwischen parallel oder senkrecht zu den Gräben zueinander benachbarte Halbleiterstrukturen sind isolierende Strukturen angeordnet, die zwischen den Gräben angeordnet sind.

Der Erfindung liegt das Problem zugrunde, eine DRAM-Zellenanordnung anzugeben, die als Speicherzellen Eintransistor-Speicherzellen umfaßt und die mit besonders hoher Packungsdichte herstellbar ist. Ferner soll ein Herstellungsverfahren für eine solche DRAM-Zellenanordnung angegeben werden.

Dieses Problem wird gelöst durch eine DRAM-Zellenanordnung gemäß Anspruch 1 sowie ein Verfahren zu deren Herstellung gemäß Anspruch 13. Weitere Ausgestaltungen und Erfindungen gehen aus den übrigen Ansprüchen hervor.

In einer erfindungsgemäßen DRAM-Zellenanordnung umfassen Speicherzellen jeweils eine Halbleiterstruktur, die mindestens eines von zwei Source/Drain-Gebieten und ein darunter angeordnetes Kanalgebiet eines vertikalen Auswahltransistors umfaßt. Der Auswahltransistor ist als MOS-Transistor ausgebildet. Die Halbleiterstruktur weist zwei sich gegenüberliegende Flanken auf, an die das Source/Drain-Gebiet angrenzt. Das Kanalgebiet grenzt an eine der zwei Flanken der Halbleiterstruktur an. An das Kanalgebiet grenzt ein Gatedielektrikum an, an das eine Gateelektrode, die mit einer ersten Wortleitung verbunden ist, angrenzt. An einer anderen der zwei Flanken der Halbleiterstruktur ist in einer Höhe des Kanalgebiets ein Element, das die Ausbildung eines Kanals verhindert, angeordnet. An das Element, das die Ausbildung eines Kanals verhindert, grenzt eine zweite Wortleitung an. Das Element ist unterhalb des Source/Drain-Gebiets angeordnet, so daß die DRAM-Zellenanordnung eine höhere Packungsdichte als die DRAM-Zellenanordnung gemäß US 4 630 088. Ein erstes Source/Drain-Gebiet des Auswahltransistors ist mit einem Speicherkondensator verbunden. Ein zweites Source/Drain-Gebiet des Auswahltransistors ist mit einer Bitleitung, die quer zu der ersten Wortleitung verläuft, verbunden. Eine Speicherzelle der DRAM-Zellenanordnung läßt sich mit einer Fläche von 4F² herstellen.

Das Element, das die Ausbildung eines Kanals verhindert, kann als Channel-Stop-Gebiet ausgebildet sein. Das Channel-Stop-Gebiet ist vom selben Leitfähigkeitstyp wie der des Kanalgebiets dotiert, weist jedoch eine höhere Dotierstoffkonzentration auf. Zur Erzeugung der Channel-Stop-Gebiete können zweite Gräben erzeugt werden, die Halbleiterstrukturen voneinander trennen. Durch schräge Implantation an ersten Flanken und/oder an zweiten Flanken der zweiten Gräben entstehen die Channel-Stop-Gebiete. Channel-Stop-Gebiete können auch durch Ausdiffusion von Dotierstoff eines Hilfsmaterials, das anschließend wieder entfernt wird, entstehen. Alternativ können an den ersten Flanken und/oder an den zweiten Flanken der zweiten Gräben die Elemente in Form von Spacern aus isolierendem Material erzeugt werden.

Es ist vorteilhaft, die DRAM-Zellenanordnung mit folded Bitleitungen auszubilden. Dazu werden entlang der zweiten Gräben jeweils zwei Wortleitungen erzeugt. Elemente, die die Ausbildung von Kanälen verhindern, von entlang einer Wortleitung benachbarten Speicherzellen, werden alternierend angrenzend an erste Flanken und zweite Flanken der zweiten Gräben angeordnet. Dadurch ist die Wortleitung, über die ein Auswahltransistor, der mit einer Bitleitung verbunden ist, angesteuert wird, mit keinem Auswahltransistor verbunden, der mit einer der Bitleitung benachbarten Bitleitung verbunden ist. Elemente, die die Ausbildung von Kanälen verhindern, von entlang der Bitleitung benachbarten Speicherzellen können z.B. alle entweder an erste Flanken oder alle an zweite Flanken der zweiten Gräben angrenzen. Alternativ können die Elemente, die die Ausbildung von Kanälen verhindern, von entlang der Bitleitung benachbarten Speicherzellen alternierend an die ersten Flanken und an die zweiten Flanken der zweiten Gräben angrenzen. Wortleitungen können in Form von Spacern gebildet werden.

Zur Prozeßvereinfachung liegt es im Rahmen der Erfindung auf folded Bitleitungen zu verzichten. Die zweiten Gräben werden jeweils durch eine Wortleitung im wesentlichen aufgefüllt. Damit Speicherzellen, die mit derselben Bitleitung verbunden sind, jeweils von verschiedenen Wortleitungen angesteuert werden, sind die Elemente, die die Ausbildung von Kanälen verhindern, von entlang der Bitleitung benachbarten Speicherzellen alle entweder angrenzend an erste Flanken oder alle an zweite Flanken der zweiten Gräben ausgebildet. Werden die Elemente, die die Ausbildung von Kanälen verhindern, in Form von durch schräge Implantation erzeugten Channel-Stop-Gebieten realisiert, ist es zur Verringerung des Prozeßaufwands vorteilhaft, wenn die Elemente alle angrenzend an die ersten Flanken oder die zweiten Flanken der zweiten Gräben ausgebildet werden. Dadurch kann auf Masken bei der Erzeugung der Channel-Stop-Gebiete, verzichtet werden.

Der Speicherkondensator kann entweder in einem Substrat vergraben sein oder oberhalb des Substrats angeordnet sein.

Ist der Kondensator oberhalb des Substrats angeordnet, kann das zweite Source/Drain-Gebiet entweder Teil der Bitleitung sein oder über eine leitende Struktur mit der Bitleitung verbunden sein. In beiden Fällen können parallel zu den Bitleitungen verlaufende erste Gräben erzeugt werden, die bis zu den Oberkanten zumindest teilweise mit isolierendem Material gefüllt werden, das an die Bitleitungen angrenzt. Das isolierende Material bildet erste isolierende Strukturen. Quer zu den ersten Gräben werden die zweiten Gräben erzeugt, die jeweils zumindest teilweise flacher als die ersten Gräben sind, indem mit Hilfe einer Maske in Gebieten, die sich mit den ersten Gräben überschneiden, das isolierende Material und in Gebieten, die außerhalb der ersten Gräben liegen, das Halbleitermaterial geätzt werden. Die Wortleitungen werden innerhalb der zweiten Gräben erzeugt. Die ersten isolierenden Strukturen trennen entlang jeweils einer der zweiten Gräben benachbarte Speicherzellen voneinander.
Ist das zweite Source/Drain-Gebiet Teil der Bitleitung, so können z.B. durch Implantation und/oder Epitaxie, eine Schicht für Bitleitungen, darüber eine Schicht für Kanalgebiete und darüber eine Schicht für Source/Drain-Gebiete erzeugt werden. Die Schicht für die Kanalgebiete ist von einem zu Leitfähigkeitstypen der Schicht für die Bitleitungen und der Schicht für die Source/Drain-Gebiete entgegengesetzen Leitfähigkeitstyp dotiert. Zur Erzeugung der Bitleitungen werden die parallel zueinander verlaufenden ersten Gräben erzeugt, die die Schicht für die Bitleitungen durchtrennen. Dadurch entstehen zwischen den ersten Gräben aus der Schicht für die Bitleitungen die Bitleitungen. Die ersten isolierenden Strukturen isolieren die Bitleitungen voneinander. Durch die Erzeugung der ersten Gräben und der zweiten Gräben entstehen aus der Schicht für die Source/Drain-Gebiete und aus der Schicht für die Kanalgebiete das erste Source/Drain-Gebiet und das Kanalgebiet.

Ist das zweite Source/Drain-Gebiet über eine leitende Struktur mit der Bitleitung verbunden, so kann die Bitleitung bezüglich einer Achse, die senkrecht zu einer Oberfläche des Substrats verläuft, unterhalb von und lateral zu dem zweiten Source/Drain-Gebiet angeordnet sein. Dazu werden die Bitleitungen entlang der ersten Gräben erzeugt.
Das Substrat kann eine Schicht für die Kanalgebiete umfassen, die z.B. durch Implantation und/oder Epitaxie erzeugt wird. Das Substrat kann sowohl vom Leitfähigkeitstyp der Schicht für die Kanalgebiete als auch von einem entgegengesetzten Leitfähigkeitstyp dotiert sein. Das erste Source/Drain-Gebiet entsteht z.B. durch Erzeugung der ersten Gräben und der zweiten Gräben aus einer Schicht für die Source/Drain-Gebiete, die z.B. durch ganzflächige Implantation in der Schicht für die Kanalgebiete erzeugt wird.

Alternativ kann das erste Source/Drain-Gebiet durch maskierte Implantation erzeugt werden.
Das zweite Source/Drain-Gebiet entsteht z.B. an einem Teil eines Bodens eines der zweiten Gräben z.B. durch Implantation und Tempern. Das Tempern aktiviert nicht nur den Dotierstoff sondern bewirkt eine Ausdehnung des zweiten Source/Drain-Gebiets insbesondere seitlich und in die Höhe, wodurch die Höhe des zweiten Source/Drain-Gebiets oberhalb des Bodens des zweiten Grabens liegt.
Alternativ wird das zweite Source/Drain-Gebiet vor der Schicht für die Kanalgebiete erzeugt, die dann durch Epitaxie erzeugt wird.

Die Bitleitungen können durch Implantation von Böden der ersten Gräben erzeugt werden.

Alternativ entstehen die Bitleitungen, indem die ersten Gräben teilweise mit dotiertem Polysilizium gefüllt werden. Zur Isolation der Bitleitungen vom Substrat wird in einem Temperschritt Dotierstoff aus den Bitleitungen ausdiffundiert, wodurch ein zweites Diffusionsgebiet entsteht, das die Bitleitungen vom Substrat trennt. Das Substrat ist von einem zum Leitfähigkeitstyp der Bitleitungen entgegengesetzten Leitfähigkeitstyp dotiert. Statt das dotierte Polysilizium als die Bitleitungen zu verwenden, kann nach Erzeugung der zweiten Diffusionsgebiete, das Polysilizium entfernt werden. Anschließend wird ein anderes leitendes Material abgeschieden und geätzt, aus dem die Bitleitungen entstehen, die durch die zweiten Diffusionsgebiete vom Substrat elektrisch isoliert werden.

Alternativ können die Seiten der ersten Gräben zunächst mit einer dritten isolierenden Struktur versehen werden. Durch teilweises Auffüllen der ersten Gräben mit leitendem Material, wie z.B. Silizid, Polyzid, Polysilizium und/oder Metall, entstehen dann die Bitleitungen, die durch die dritten isolierenden Strukturen vom Substrat getrennt sind.

Um die Kapazität, die durch die Bitleitung und das Substrat gebildet wird, klein zu halten ist es vorteilhaft, wenn die dritten isolierenden Strukturen Material mit einer niedrigen Dielektrizitätskonstante, wie z.B. Borsilikatglas, enthalten. Es ist vorteilhaft, nach Erzeugung der Bitleitungen freiliegende Teile der dritten isolierenden Strukturen zu entfernen. Dadurch verringert sich der Prozeßaufwand, falls bei mehreren Prozeßschritten Teile von Flanken der ersten Gräben freigelegt werden sollen. Werden die ersten isolierenden Strukturen vor der leitenden Struktur erzeugt, so wird mindestens ein Teil einer der ersten isolierenden Strukturen, der an eine Flanke des ersten Grabens, an der die leitende Struktur entstehen soll, angrenzt, entfernt, bis die Bitleitung teilweise freiliegt.

Um die Kapazität, die durch die Bitleitung und das Substrat gebildet wird, besonders klein zu halten, können sowohl zweite Diffusionsgebiete als auch dritte isolierende Strukturen gebildet werden.

Für die leitende Struktur wird z.B. durch schräge Implantation ein erstes Diffusionsgebiet erzeugt, das an die Bitleitung und an das zweite Source/Drain-Gebiet angrenzt.

Die leitende Struktur kann auch durch Abscheiden und Rückätzen von leitendem Material erzeugt werden. Zur Isolation des leitenden Materials vom Substrat kann z.B. das leitende Material in Form von dotiertem Polysilizium vorliegen. Durch Ausdiffusion in einem Temperschritt entsteht das erste Diffusionsgebiet, das nicht nur als zusätzliches Teil der leitenden Struktur dient, sondern das dotierte Polysilizium vom Substrat elektrisch isoliert. Dazu ist das Substrat von einem zum Leitfähigkeitstyp des dotierten Polysiliziums entgegengesetzten Leitfähigkeitstyp dotiert. Alternativ kann isolierendes Material, z.B. ein Teil der dritten isolierenden Struktur oder eine spacerförmige Struktur, das leitende Material vom Substrat isolieren. Das leitende Material kann dann z.B. Metall, Metallsilizid oder dotiertes Polysilizium enthalten.
Es liegt im Rahmen der Erfindung oberhalb des zweiten Source/Drain-Gebiets eine sechste Hilfsschicht aus isolierendem Material und darüber eine siebte Hilfsschicht zu erzeugen. Die siebte Hilfsschicht schützt die sechste Hilfsschicht bei der teilweisen Entfernung der ersten isolierenden Struktur vor der Erzeugung der leitenden Struktur. Die sechste Hilfsschicht schützt darunterliegende Teile der DRAM-Zellennordnung bei der Ätzung des leitenden Materials zur Erzeugung der leitenden Struktur.

Damit bei der Erzeugung der Wortleitungen einer DRAM-Zellenanordnung mit folded Bitleitungen die Wortleitungen durch unerwünschte Bildung von Spacern an quer zu den zweiten Gräben verlaufende Kanten nicht kurzgeschlossen werden, müssen die zweiten Gräben mit im wesentlichen ebenen Böden versehen werden. Dazu stimmen die Ätztiefe beim Ätzen des isolierenden Materials und die Ätztiefe beim Ätzen des Halbleitermaterials ungefähr miteinander überein.

Der Grad an Übereinstimmung der Ätztiefen darf geringer sein, wenn die ebenen Böden nachträglich als Flächen von Bodenstrukturen entstehen. Die Bodenstrukturen werden nach Erzeugung der leitenden Struktur durch Abscheiden von Material, das mindestens die zweiten Gräben füllt, und Ätzen bis zu einer Tiefe, die bezüglich der Achse höher als die ursprünglich höchste Tiefe der zweiten Gräben ist, erzeugt.

Zur Isolierung der Wortleitungen und/oder zur Verkleinerung von Kapazitäten, an denen die Wortleitungen beteiligt sind, werden die Bodenstrukturen vorzugsweise aus isolierendem Material hergestellt.

Damit die Gateelektrode, die innerhalb eines mit einem ebenen Boden versehenen zweiten Grabens erzeugt wird, das zweite Source/Drain-Gebiet ansteuern kann, darf die Höhe der ebenen Böden die Höhe des zweiten Source/Drain-Gebiets nicht überschreiten. Die Höhe des zweiten Source/Drain-Gebiets liegt nicht wesentlich über der Höhe der ursprünglichen Böden der zweiten Gräben, wenn das zweite Source/Drain-Gebiet vor Erzeugung der Bodenstrukturen durch Implantation und Tempern an einem Teil der Böden der zweiten Gräben erzeugt wird. Werden die ebenen Böden der zweiten Gräben durch Bodenstrukturen gebildet, so ist die vertikale Toleranz für die Einstellung der Höhe der ebenen Böden demnach gering. Deshalb ist es vorteilhaft, nach Erzeugung des zweiten Source/Drain-Gebiets Halbleitermaterial zu ätzen, so daß die zweiten Gräben teilweise tiefer werden. Dadurch läßt sich die vertikale Toleranz bei der Einstellung der Höhe der ebenen Böden vergrößern. Ist das zweite Source/Drain-Gebiet Teil der Bitleitung genügt es zur Vergrößerung der vertikalen Toleranz, die zweiten Gräben tief genug zu erzeugen, da die Höhe des zweiten Source/Drain-Gebiets in diesem Fall nicht durch die Tiefe der zweiten Gräben beeinflußt wird.

Es liegt im Rahmen der Erfindung nach Erzeugung der ersten isolierenden Strukturen auf dem zweiten Source/Drain-Gebiet eine erste Hilfsschicht aus isolierendem Material zu erzeugen, die die vertikale Toleranz bei der Rückätzung zur Erzeugung der spacerförmigen Wortleitungen vergrößert. Die Gateelektrode kann teilweise an die erste Hilfsschicht angrenzen.

Es liegt im Rahmen der Erfindung nach Erzeugung der ersten isolierenden Strukturen auf dem zweiten Source/Drain-Gebiet eine zweite Hilfsschicht und darüber eine dritte Hilfsschicht zu erzeugen. Die dritte Hilfsschicht wird mit Hilfe eines fotolithografischen Verfahrens strukturiert, dient als Maske bei der Erzeugung der zweiten Gräben und schützt die zweite Hilfsschicht. Die zweite Hilfsschicht ist selektiv zur ersten isolierenden Struktur und dem Material zur Erzeugung des ebenen Bodens ätzbar. Bei der Erzeugung des ebenen Bodens dient die zweite Hilfsschicht als Maske und schützt Teile der ersten isolierenden Strukturen. Wird auch die erste Hilfsschicht erzeugt, so wird die zweite Hilfsschicht auf der ersten Hilfsschicht angeordnet. Werden auch die sechste Hilfsschicht und die siebte Hilfsschicht erzeugt, so wird die sechste Hilfsschicht auf der zweiten Hilfsschicht und die dritte Hilfsschicht auf der siebten Hilfsschicht erzeugt.

Wird nur die erste Hilfsschicht erzeugt, kann sie als Maske bei der Erzeugung der zweiten Gräben dienen.

Es liegt im Rahmen der Erfindung Kontakte zu Source/Drain-Gebieten zu erzeugen. Ist der Speicherkondensator oberhalb des Substrats angeordnet, so verbinden die Kontakte die ersten Source/Drain-Gebiete mit ersten Kondensatorplatten der Speicherkondensatoren. Ist der Speicherkondensator im Substrat vergraben, so verbinden die Kontakte die zweiten Source/Drain-Gebiete mit den Bitleitungen.

Die Kontakte können durch maskiertes Ätzen einer dritten isolierenden Struktur und Auffüllen der dabei entstehenden Vertiefungen mit leitendem Material erzeugt werden.

Zur Erhöhung der Packungsdichte können die Kontakte selbstjustiert, d.h. ohne Verwendung von zu justierenden Masken, erzeugt werden. Dazu wird über den Source/Drain-Gebieten die erste Hilfsschicht aus isolierendem Material und die zweite Hilfsschicht aus Halbleitermaterial erzeugt. Nach Erzeugung der Gateelektroden wird isolierendes Material abgeschieden und planarisiert, bis die zweite Hilfsschicht freigelegt wird. Anschließend wird Halbleitermaterial selektiv zum isolierenden Material geätzt, bis die zweite Hilfsschicht entfernt wird. Dadurch entstehen oberhalb der Source/Drain-Gebiete Vertiefungen, und das isolierende Material ist oberhalb der Source/Drain-Gebiete dünner als oberhalb der Gateelektroden. Wird nun anschließend das isolierende Material geätzt, bis die erste Hilfsschicht entfernt und die Source/Drain-Gebiete freigelegt werden, verschieben sich die Vertiefungen nach unten, und über den Gateelektroden bleibt isolierendes Material übrig. Durch Abscheiden von leitendem Material und Ätzen, bis isolierendes Material freigelegt wird, entstehen dadurch in den Vertiefungen die Kontakte.

Alternativ kann auf die Kontakte verzichtet werden. Dazu werden die Gateelektroden bis unterhalb einer Oberkante der Source/Drain-Gebiete zurückgeätzt. Eine zweite isolierende Struktur wird erzeugt, indem isolierendes Material abgeschieden und geätzt wird, bis die Source/Drain-Gebiete freigelegt werden, aber die Gateelektroden nicht freigelegt werden. Nun werden die ersten Kondensatorplatten bzw. die Bitleitungen durch Abscheiden und Strukturieren von leitendem Material, wie z.B Wolfram, Platin oder Polysilizium, direkt angrenzend an die Source/Drain-Gebiete erzeugt.

Ist der Speicherkondensator im Substrat vergraben, ist es vorteilhaft, wenn eine hoch dotierte Schicht für die ersten Source/Drain-Gebiete erzeugt wird. Die Schicht für die ersten Source/Drain-Gebiete wird z.B. durch Implantation des Substrats erzeugt. Durch Epitaxie wird auf der Schicht für die ersten Source/Drain-Gebiete eine schwach dotierte Schicht für die Kanalgebiete erzeugt. Die zweiten Source/Drain-Gebiete werden durch Implantation und/oder Epitaxie erzeugt. Dazu können durch Implantation mit Hilfe einer Maske in der Schicht für die Kanalgebiete Gebiete für die zweiten Source/Drain-Gebiete erzeugt werden. Die Gebiete für die zweiten Source/Drain-Gebiete können z.B. streifenförmig, zueinander parallel verlaufend und hochdotiert sein. Es liegt im Rahmen der Erfindung, oberhalb der zweiten Source/Drain-Gebiete eine vierte Hilfsschicht aus isolierendem Material, eine fünfte Hilfsschicht aus Halbleitermaterial und die dritte Hilfsschicht aus isolierendem Material zu erzeugen.
Es liegt im Rahmen der Erfindung, vor Erzeugung der vierten Hilfsschicht die erste Hilfsschicht und darüber die zweite Hilfsschicht zu erzeugen, mit den zugehörigen, weiter oben erwähnten Eigenschaften und Funktionen bei der Erzeugung der Kontakte. Zur Erzeugung der zweiten Gräben dient die strukturierte dritte Hilfsschicht als Maske. Sind die Gebiete für die zweiten Source/Drain-Gebiete streifenförmig, so werden die zweiten Gräben senkrecht zu den Gebieten erzeugt, wodurch die zweiten Source/Drain-Gebiete aus den Gebieten entstehen.

Es liegt im Rahmen der Erfindung, nach Erzeugung der Channel-Stop-Gebiete isolierendes Material abzuscheiden und zu planarisieren, bis die fünfte Hilfsschicht freigelegt wird. Die dritte Hilfsschicht wird dabei entfernt. Mit Hilfe einer zu der Maske für die Erzeugung der Gebiete der zweiten Source/Drain-Gebiete komplementären Maske wird das isolierende Material aus den zweiten Gräben teilweise entfernt, wobei die fünfte Hilfsschicht die vierte Hilfsschicht schützt. Dadurch entstehen in den zweiten Gräben lochartige Vertiefungen, in denen die ersten Source/Drain-Gebiete durch Implantation und Tempern erzeugt werden. Übrigbleibendes isolierendes Material in den zweiten Gräben dient als isolierende Struktur, die entlang eines zweiten Grabens benachbarte Transistoren, voneinander trennt. Die Speicherknoten werden selbstjustiert mit den ersten Source/Drain-Gebieten verbunden, indem nach Erzeugung der ersten Source/Drain-Gebiete Halbleitermaterial geätzt wird, ein Kondensatordielektrikum erzeugt wird und anschließend leitendes Material abgeschieden und rückgeätzt wird, bis die Höhe der Speicherknoten im Bereich der ersten Source/Drain-Gebiete liegt. Dabei wird die fünfte Hilfsschicht entfernt, und die vierte Hilfsschicht schützt die zweiten Source/Drain-Gebiete bzw. die zweite Hilfsschicht. Freiliegende Teile des Kondensatordielektrikums werden entfernt, um eine Verbindung zwischen dem Speicherknoten und den ersten Source/Drain-Gebieten zu ermöglichen. Anschließend wird leitendes Material abgeschieden und rückgeätzt, so daß die Speicherknoten jeweils mit einem der ersten Source/Drain-Gebiete verbunden sind. Nach Erzeugung eines Gatedielektrikums werden die Gateelektroden selbstjustiert zu den Speicherknoten erzeugt, indem Material abgeschieden und geätzt wird.
Zur Erhöhung der Kapazität des Speicherkondensators ist es vorteilhaft, wenn eine Schicht des Substrats, an der das Kondensatordielektrikum angrenzt, hoch dotiert ist. Die Schicht für die ersten Source/Drain-Gebiete wird dann epitaktisch auf die Schicht des Substrats aufgewachsen. Alternativ kann auch das Substrat im wesentlichen nur in der Umgebung des Kondensatordielektrikums hoch dotiert werden. Dazu wird vor Erzeugung des Speicherknotens Dotierstoff in das Substrat eingebracht. Dies geschieht z.B. durch Abscheiden von dotiertem Polysilizium, Tempern und anschließendem Entfernen des Polysiliziums.

Das erste Source/Drain-Gebiet kann generell entweder n-dotiert oder p-dotiert sein.

Zur Vergrößerung der Kapazität des Speicherkondensators ist es vorteilhaft, wenn das Kondensatordielektrikum Material mit einer hohen Dielektrizitätskonstante, wie z.B. BaₓSr₁₋ₓTiO₃, Tantalpentoxid oder Perovskite, enthält. Zur Bildung guter Grenzflächen ist es für den Fall, daß der Speicherkondensator oberhalb des Substrats angeordnet ist, bei einigen Materialien mit hohen Dielektrizitätskonstanten, vorteilhaft, wenn die Kondensatorplatten Platin, Ruthenium, Iridium und/oder Rutheniumoxid enthalten. Für den Fall, daß der Speicherkondensator im Substrat vergraben ist, ist es einfacher, wenn das Kondensatordielektrikum SiO₂, eine ON-Schicht, eine NO-Schicht und/oder eine ONO-Schicht umfaßt. Dabei steht 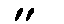 O" für ein Oxid und 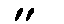 N" für Siliziumnitrid.

Im folgenden werden Ausführungsbeispiele der Erfindung, die in den Figuren dargestellt sind, näher erläutert.
- Fig. 1: zeigt einen Querschnitt durch ein erstes Substrat, das eine Schicht für Kanalgebiete umfaßt, in dem eine Schicht für Source/Drain-Gebiete erzeugt wurde.
- Fig. 2: zeigt den Querschnitt aus Fig. 1, nachdem erste Gräben, Bitleitungen und erste isolierende Strukturen erzeugt wurden.
- Fig. 3 a: zeigt einen zu Fig. 2 senkrechten Querschnitt, nachdem eine erste Hilfsschicht, eine zweite Hilfsschicht, eine dritte Hilfsschicht ,zweite Gräben, erste Source/Drain-Gebiete, Kanalgebiete, zweite Spacer und zweite Source/Drain-Gebiete erzeugt wurden.

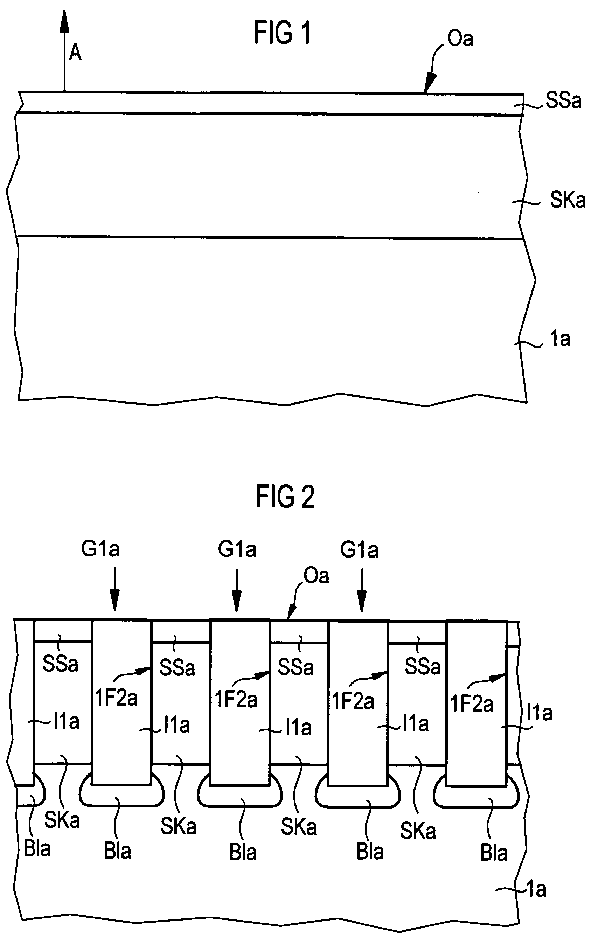

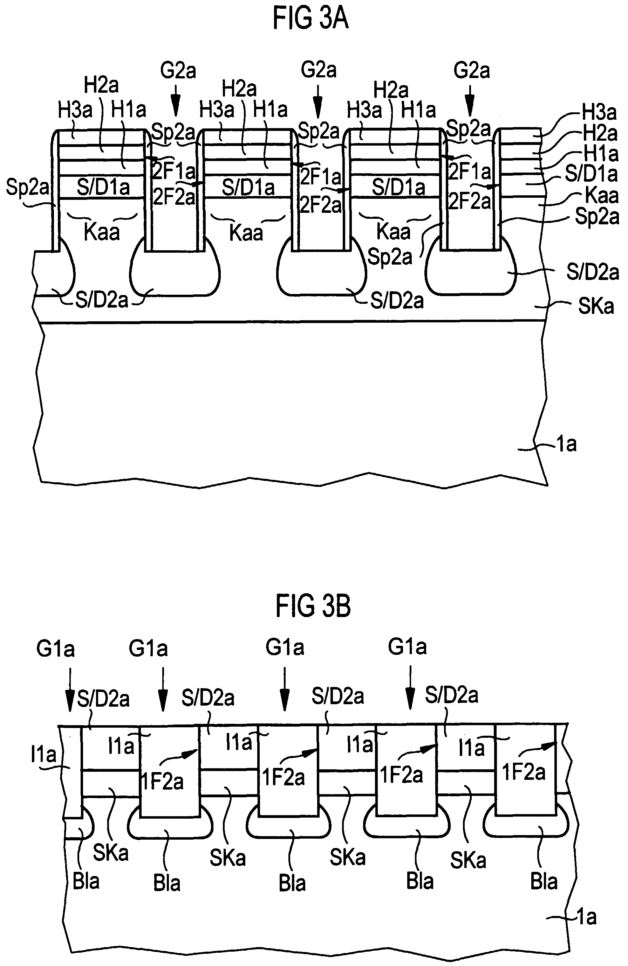

- Fig. 3 b: zeigt den Querschnitt aus Fig. 2 nach den Schritten aus Fig. 3a.

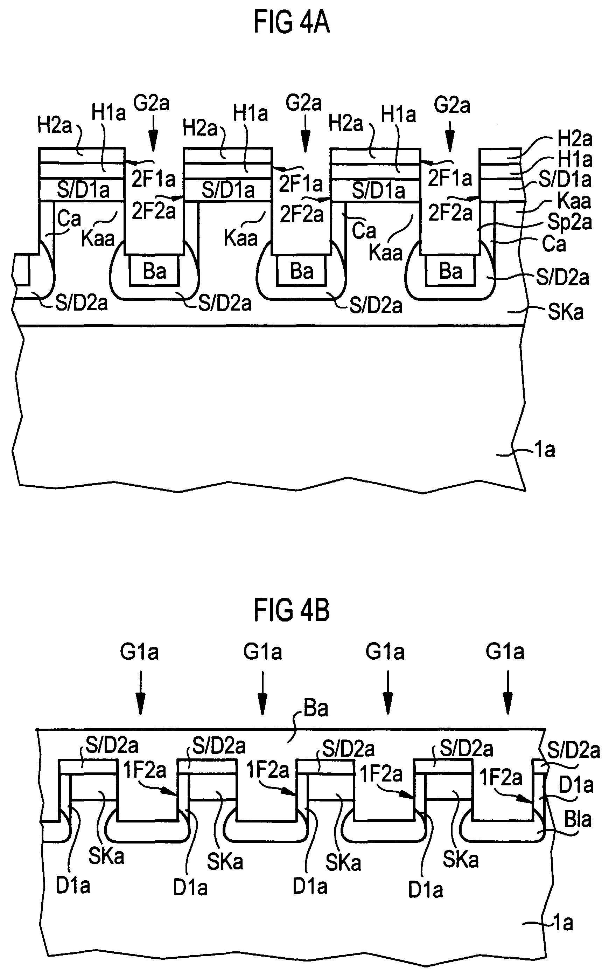

- Fig. 4 a: zeigt den Querschnitt aus Fig. 3 a, nachdem erste Diffusionsgebiete (in Fig. 4b dargestellt), Bodenstrukturen und Channel-Stop-Gebiete erzeugt wurden.
- Fig. 4 b: zeigt den Querschnitt aus Fig. 3b, nach den Prozeßschritten aus Fig. 4 a.

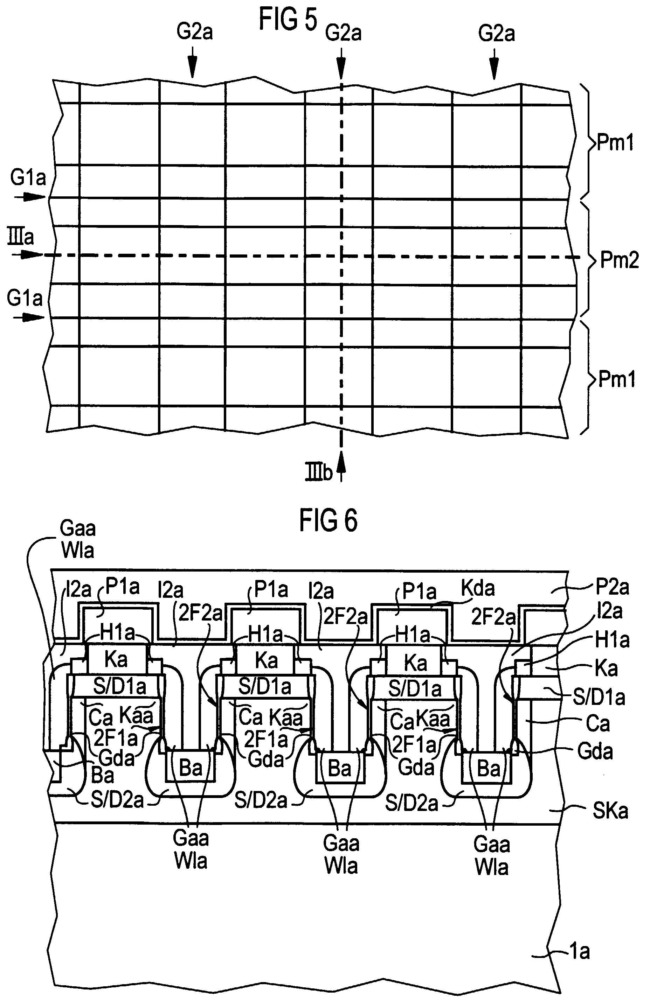

- Fig. 5: zeigt eine Aufsicht auf das erste Substrat, in der die erste Fotolackmaske und die zweite Fotolackmaske, mit deren Hilfe die Channel-Stop-Gebiete erzeugt werden, und die ersten Gräben und die zweite Gräben dargestellt sind.
- Fig. 6: zeigt den Querschnitt aus Fig. 4 a, nachdem ein Gatedielektrikum, Wortleitungen, Gateelektroden, eine zweite isolierende Struktur, Kontakte, erste Kondensatorplatten, ein Kondensatordielektrikum und eine zweite Kondensatorplatte erzeugt wurden.

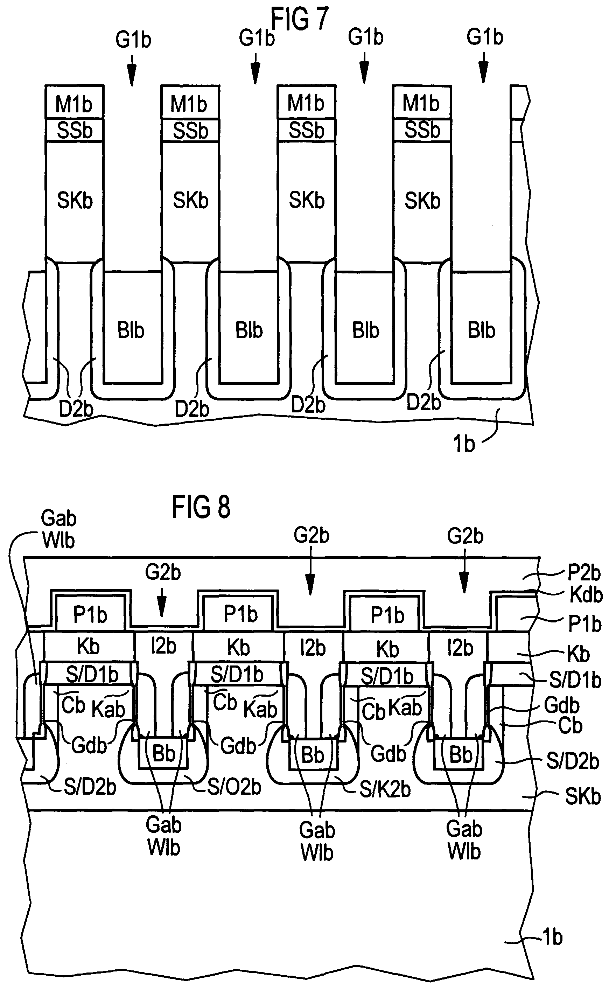

- Fig. 7: zeigt einen Querschnitt durch ein zweites Substrat, nachdem eine Schicht für Kanalgebiete, eine Schicht für Source/Drain-Gebiete, eine erste Maske, erste Gräben, Bitleitungen und zweite Diffusionsgebiete erzeugt wurden.
- Fig. 8: zeigt einen zum Querschnitt aus Fig. 7 senkrechten Querschnitt, nachdem zweite Gräben, zweite Source/Drain-Gebiete, erste Diffusionsgebiete (in dieser Figur nicht dargestellt), Bodenstrukturen, Channel-Stop-Gebiete, ein Gatedielektrikum, Wortleitungen, Gateelektroden, eine zweite isolierende Struktur, Kontakte, erste Kondensatorplatten, ein Kondensatordielektrikum und eine zweite Kondensatorplatte erzeugt wurden.

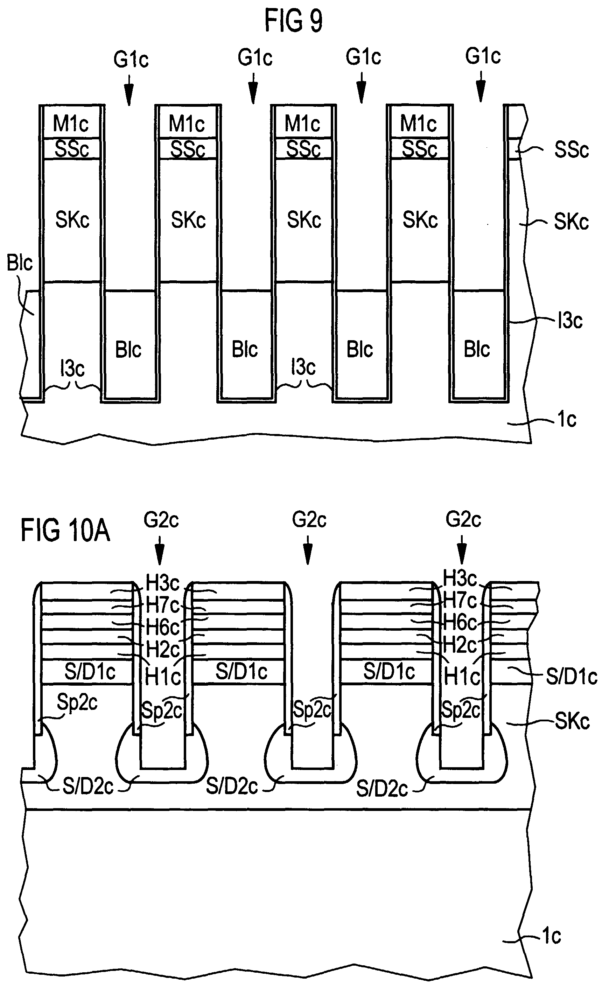

- Fig. 9: zeigt einen Querschnitt durch ein drittes Substrat, nachdem eine Schicht für Kanalgebiete, eine Schicht für Source/Drain-Gebiete, eine erste Maske, erste Gräben, eine dritte isolierende Struktur und Bitleitungen erzeugt wurden.

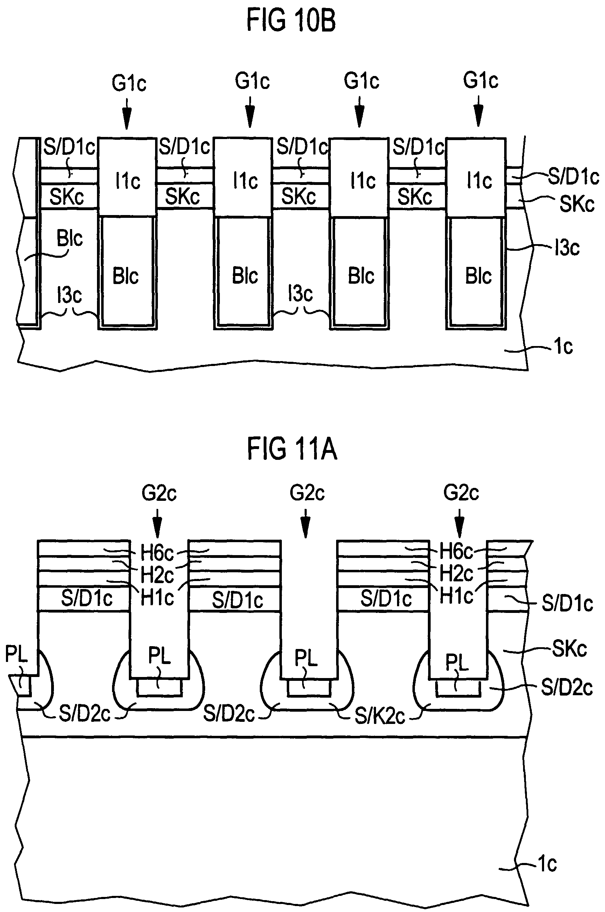

- Fig. 10 a: zeigt einen zum Querschnitt aus Fig. 9 senkrechten Querschnitt durch das dritte Substrat, nachdem erste isolierende Strukturen (in Fig. 10b dargestellt), eine erste Hilfsschicht, eine zweite Hilfsschicht, eine vierte Hilfsschicht, eine fünfte Hilfsschicht, eine dritte Hilfsschicht, zweite Gräben, zweite Spacer und zweite Source/Drain-Gebiete erzeugt wurden und die zweiten Gräben teilweise etwas tiefer geätzt wurden.
- Fig. 10 b: zeigt den Querschnitt aus Fig. 9 nach den Prozeßschritten aus Fig. 10 a.

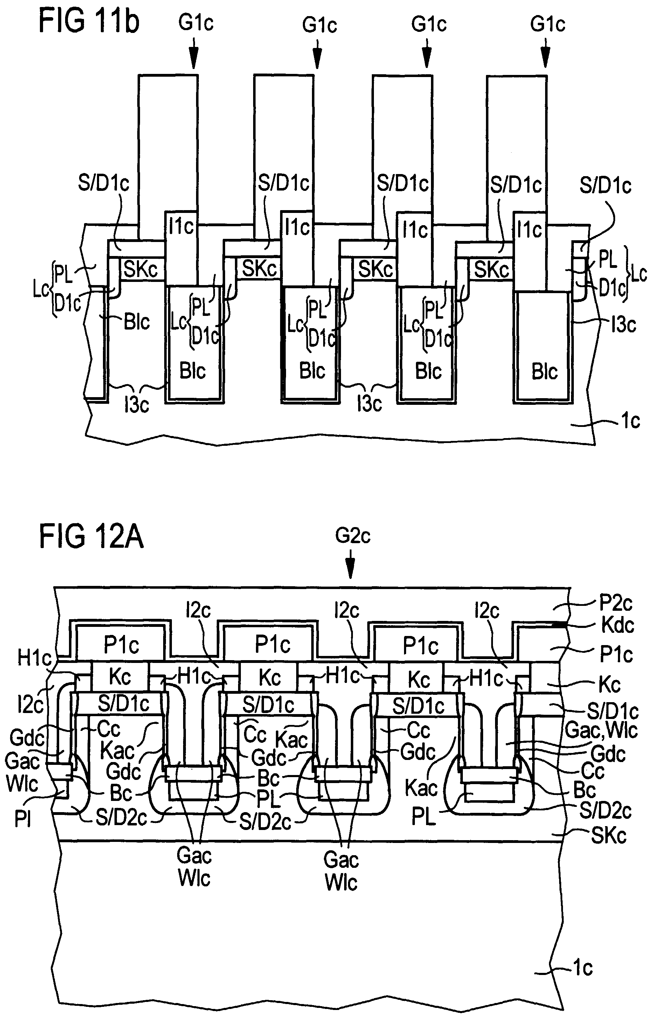

- Fig. 11 a: zeigt den Querschnitt aus Fig.10 a, nachdem als Teil von leitenden Strukturen eine Struktur aus Polysilizium und erste Diffusionsgebiete erzeugt wurden.
- Fig. 11 b: zeigt den Querschnitt aus Fig. 10 b nach den Prozeßschritten aus Fig. 11 a.

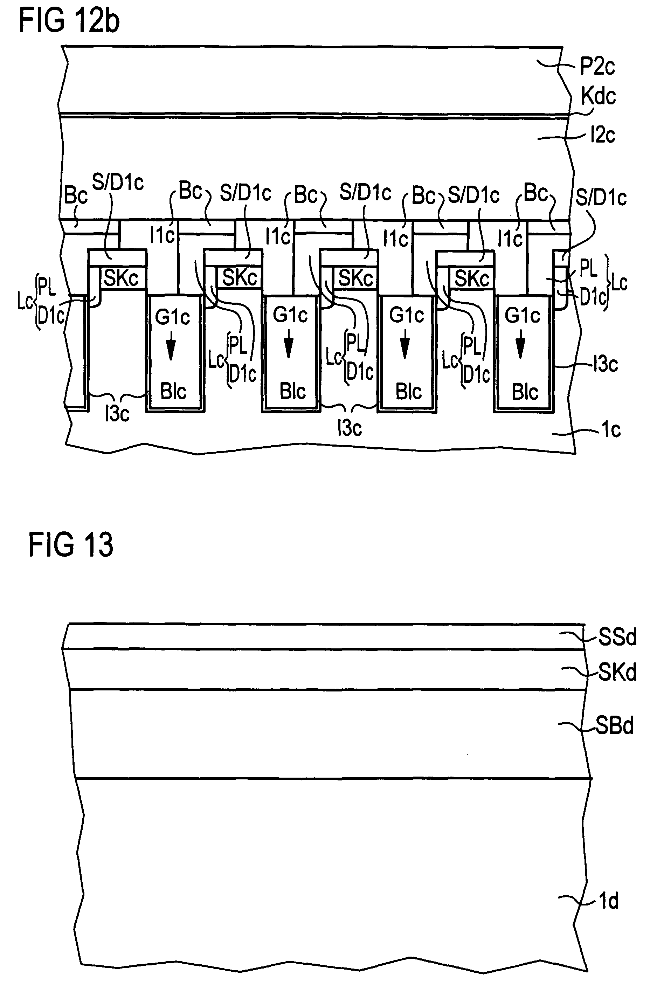

- Fig. 12 a: zeigt den Querschnitt aus Fig. 11 a nachdem Bodenstrukturen, ein Gatedielektrikum, Wortleitungen, Gateelektroden, eine zweite isolierende Struktur, Kontakte, erste Kondensatorplatten, ein Kondensatordielektrikum und eine zweite Kondesatorplatte erzeugt wurden.
- Fig. 12 b: zeigt den Querschnitt aus Fig. 11 b nach den Prozeßschritten aus Fig. 12 a.
- Fig. 13: zeigt einen Querschnitt durch ein viertes Substrat, nachdem eine Schicht für Bitleitungen, eine Schicht für Kanalgebiete und eine Schicht für Source/Drain-Gebiete erzeugt wurden.

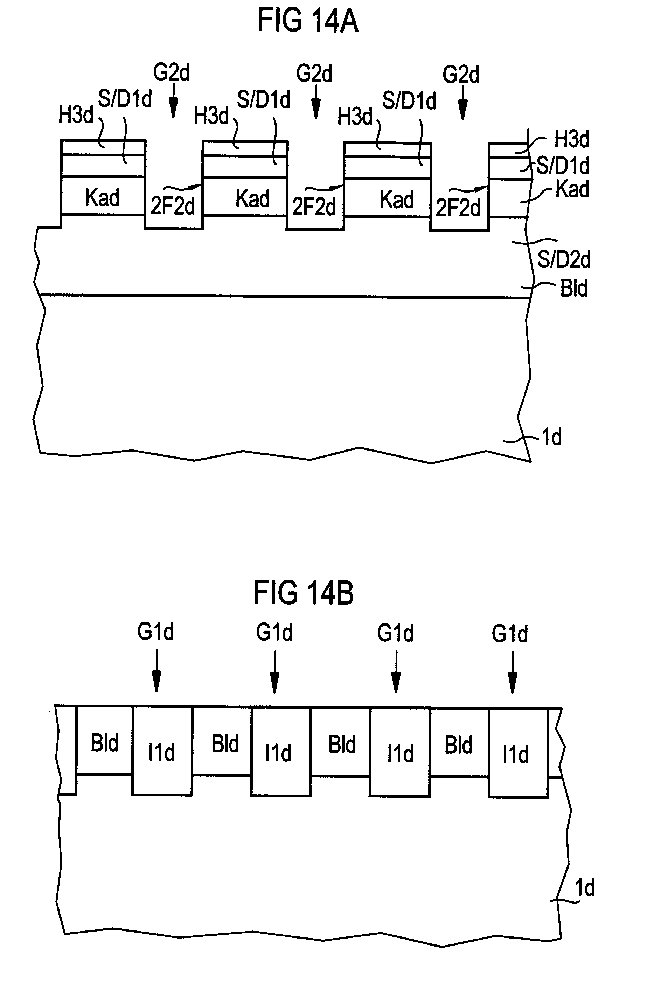

- Fig. 14 a: zeigt den Querschnitt aus Fig. 13, nachdem erste Gräben (in Figur 14b dargestellt), erste isolierende Strukturen (in Figur 14b dargestellt), eine dritte Hilfsschicht und zweite Gräben erzeugt wurden.
- Fig. 14 b: zeigt einen zum Querschnitt aus Fig. 14 a senkrechten Querschnitt durch das vierte Substrat, nach den Prozeßschritten aus Fig. 14 a. Der Querschnitt verläuft entlang eines zweiten Grabens.

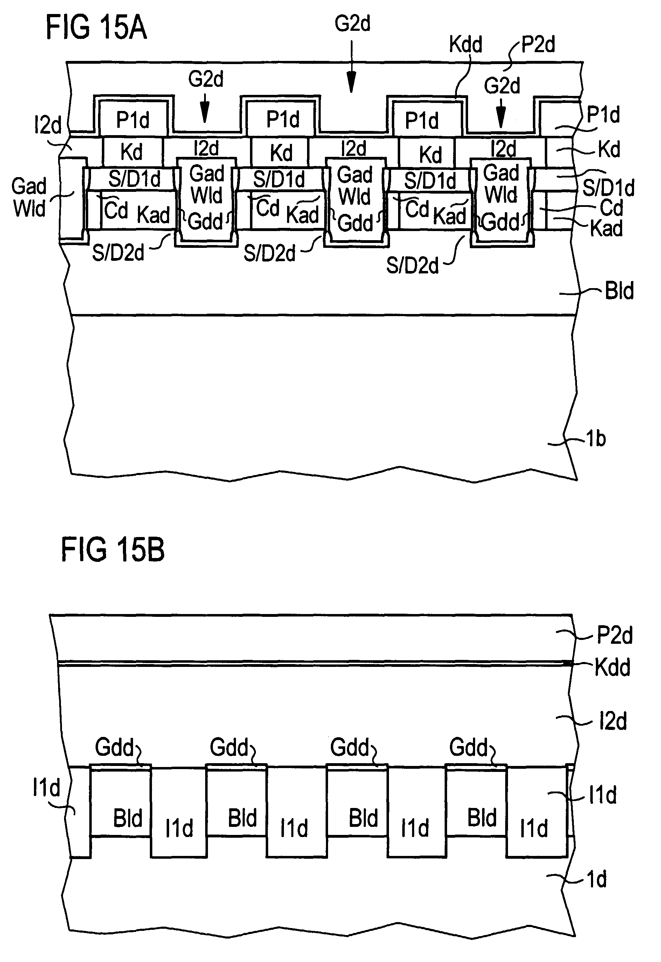

- Fig. 15 a: zeigt den Querschnitt aus Fig. 14 a, nachdem Channel-Stop-Gebiete, ein Gatedielektrikum, Wortleitungen, Gateelektroden, eine zweite isolierende Struktur, Kontakte, erste Kondensatorplatten, ein Kondensatordielektrikum und eine zweite Kondensatorplatte erzeugt wurden.
- Fig. 15 b: zeigt den Querschnitt aus Fig. 14 b nach den Prozeßschritten aus Fig. 15 a.

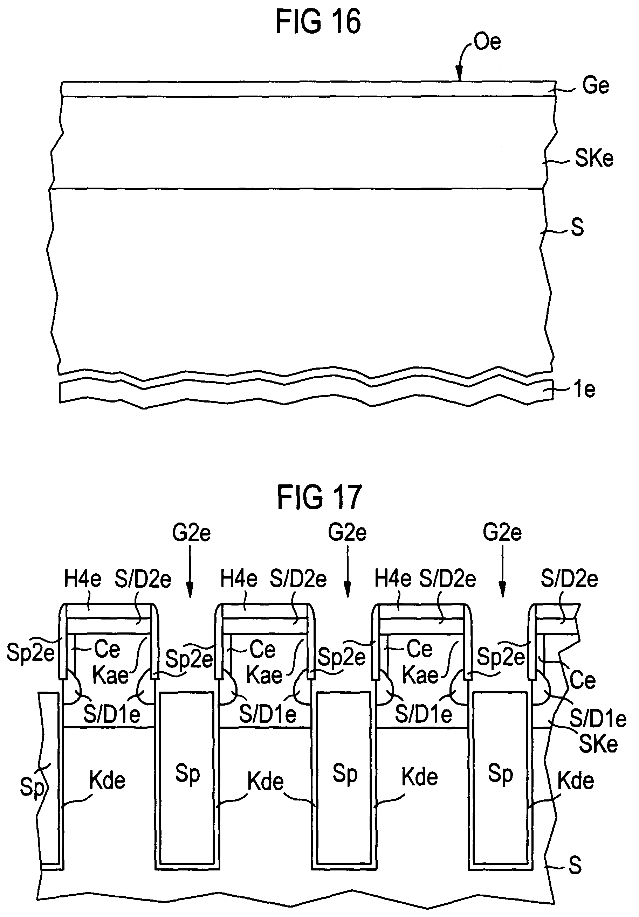

- Fig. 16: zeigt einen Querschnitt durch ein fünftes Substrat, nachdem eine Schicht, eine Schicht für Kanalgebiete und ein dotiertes Gebiet erzeugt wurden.
- Fig. 17: zeigt den Querschnitt aus Fig. 16, nachdem eine vierte Hilfsschicht, zweite Gräben, Channel-Stop-Gebiete, erste Source/Drain-Gebiete, ein Kondensatordielektrikum und Speicherknoten erzeugt wurden.

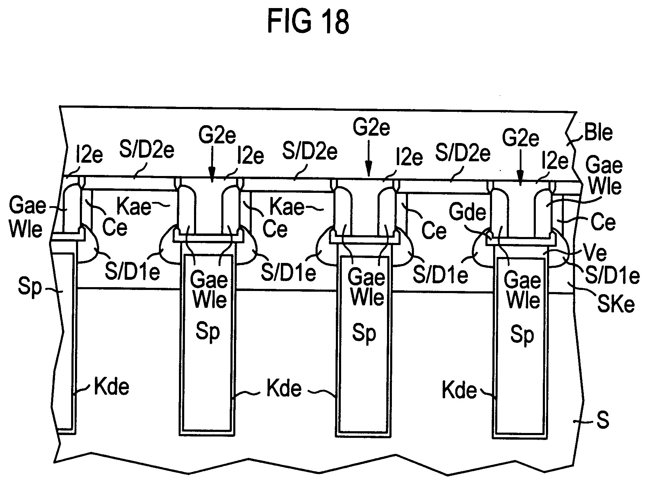

- Fig. 18: zeigt den Querschnitt aus Fig. 17, nachdem eine Verbindung, ein Gatedielektrikum, eine zweite isolierende Struktur, Wortleitungen, Gateelektroden, und Bitleitungen erzeugt wurden.

In einem ersten Ausführungsbeispiel ist ein Ausgangsmaterial ein erstes Substrat 1a, das p-dotiertes Silizium enthält und dessen Dotierstoffkonzentration ca. 10¹⁵ cm⁻³ beträgt. In einer an eine Oberfläche Oa des Substrats 1a angrenzenden p-dotierten Schicht SKa für Kanalgebiete Kaa des Substrats 1a, deren Dotierstoffkonzentration ca. 10¹⁷ cm⁻³ beträgt und die ca. 1 µm tief ist, wird durch Implantation eine n-dotierte Schicht SSa für erste Source/Drain-Gebiete S/D1a erzeugt. Die Dotierstoffkonzentration der Schicht SSa für die ersten Source/Drain-Gebiete S/D1a beträgt ca. 5x10²⁰ cm⁻³. Die Schicht SSa der ersten Source/Drain-Gebiete S/D1a ist ca. 150 nm tief (s. Fig. 1).

Zur Erzeugung einer ersten Maske (nicht dargestellt) wird SiO₂ in einer Dicke von ca. von 200 nm in einem TEOS-Verfahren abgeschieden. Durch ein photolithographisches Verfahren wird SiO₂ mit z.B. CHF₃+O₂ geätzt, wodurch die erste Maske entsteht, die streifenförmige, parallel zueinander verlaufende Gebiete bedeckt. Mit Hilfe der ersten Maske werden durch Ätzen von Silizium ca. 1,2 µm tiefe erste Gräben G1a erzeugt (s. Fig. 2). Als Ätzmittel ist z.B. HBr+NF₃+He+O₂ geeignet. Der Abstand zwischen Mittellinien zweier benachbarter erster Gräben G1a beträgt ca. 1 µm. Durch Abscheiden von SiO₂ in einer Dicke von ca. 50 nm und Rückätzen werden erste Spacer (nicht dargestellt) erzeugt. Durch Implantation werden an Böden der ersten Gräben G1a n-dotierte Bitleitungen Bla erzeugt. Die Bitleitungen sind ca. 150 nm tief und die Dotierstoffkonzentration der Bitleitungen Bla beträgt ca. 5x10²⁰ cm⁻³. Die ersten Spacer schützen Flanken der ersten Gräben G1a während der Implantation (s. Fig. 3).

Anschließend wird SiO₂ in einer Dicke von ca. 500 nm in einem TEOS-Verfahren abgeschieden und durch chemisch-mechanisches Polieren planarisiert, bis die Oberfläche Oa freigelegt wird. Dadurch entstehen erste isolierende Strukturen I1a (s. Fig. 2).

Zur Erzeugung einer ersten Hilfsschicht H1a wird SiO₂ in einer Dicke von ca. 100 nm abgeschieden. Darüber wird zur Erzeugung einer zweiten Hilfsschicht H2a Polysilizium in einer Dicke von ca. 100 nm abgeschieden. Darüber wird zur Erzeugung einer dritten Hilfsschicht H3a SiO₂ in einer Dicke von ca. 100 nm abgeschieden. In einem photolithographischen Verfahren wird zunächst SiO₂ mit z.B. CHF₃+O₂ geätzt, bis die zweite Hilfsschicht H2a teilweise freigelegt wird. Anschließend wird Polysilizium mit z. B. C₂F₆+O₂ geätzt, bis die erste Hilfsschicht H1a teilweise freigelegt wird. Anschließend wird mit CH₃+O₂ SiO₂ geätzt, bis eine Oberkante der ersten isolierenden Struktur I1a teilweise bezüglich einer Achse A, die senkrecht zur Oberfläche Oa verläuft, 500 nm unter der Oberfläche Oa liegt. Anschließend wird Silizium bis zu einer Tiefe von ca. 500 nm geätzt, wobei die dritte Hilfsschicht H3a als zweite Maske dient. Dadurch entstehen senkrecht zu den ersten Gräben G1a verlaufende zweite Gräben G2a, die in die Schicht SKa für die Kanalgebiete Kaa reichen. Der Abstand zwischen Mittellinien zweier benachbarter zweiter Gräben G2a beträgt ca. 1,25 µm (s. Fig. 3a und 3b). Durch die Erzeugung der zweiten Gräben G2a und der ersten Gräben G1a entstehen aus der Schicht SKa für die Kanalgebiete Kaa die Kanalgebiete Kaa und aus der Schicht für die ersten Source/Drain-Gebiete S/D1a die ersten Source/Drain-Gebiete S/D1a. Die ersten Source/Drain-Gebiete S/D1a und die Kanalgebiete Kaa sind seitlich von den ersten Gräben G1a und den zweiten Gräben G2a umgeben.

Zur Erzeugung zweiter Spacer Sp2a wird ca. 50 nm SiO₂ abgeschieden und rückgeätzt (s. Fig. 3a). Durch Implantation werden an Böden der zweiten Gräben n-dotierte zweite Source/Drain-Gebiete S/D2a erzeugt. Die Dotierstoffkonzentration der zweiten Source/Drain-Gebiet S/D2a beträgt ca. 5x10²⁰ cm⁻³. Durch einem Temperschritt dehnen sich die zweiten Source/Drain-Gebiete S/D2a aus, wodurch eine Oberkante der zweiten Source/Drain-Gebiete S/D2a lateral und oberhalb der Böden der zweiten Gräben G2a verläuft. Durch den Temperschritt wird auch der Dotierstoff der zweiten Source/Drain-Gebiete S/D2a aktiviert. Die zweiten Source/Drain-Gebiete S/D2a sind ca. 300 nm tief. Teile der ersten isolierenden Struktur I1a außerhalb der zweiten Gräben G2a trennen entlang der zweiten Gräben G2a benachbarte Speicherzellen voneinander. Die zweiten Spacer Sp2a schützen Flanken der zweiten Gräben G2a bei der Implantation der zweiten Source/Drain-Gebiete S/D2a.

Anschließend wird mit z. B. HBr+NF₃+He+O₂ Silizium gätzt, wodurch die zweiten Gräben G2a in Gebieten außerhalb der ersten Gräben G1a ca. 200 nm tiefer werden. Durch Ätzen von SiO₂ selektiv zu Polysilizium und Silizium werden die zweiten Spacer Sp2a und Teile der ersten isolierenden Struktur I1a, die innerhalb der zweiten Gräben G2a angeordnet sind, entfernt. Durch Abscheiden von SiO₂ in einer Dicke von ca. 50 nm und Rückätzen werden dritte Spacer (nicht dargestellt) an Flanken der zweiten Gräben G2a erzeugt. Durch schräge Implantation werden an innerhalb der zweiten Gräben G2a befindliche zweite Flanken 1F2a der ersten Gräben G1a n-dotierte erste Diffusionsgebiete D1a erzeugt. Die ersten Diffusionsgebiete D1a grenzen jeweils an eine Bitleitung Bla und an ein zweites Source/Drain-Gebiet S/D2a an. Die dritten Spacer schützen andere Flanken bei der Implantation. Die Dotierstoffkonzentration der ersten Diffusionsgebiete D1a beträgt ca. 10²⁰ cm⁻³ (s. Fig. 4b).

Anschließend wird ca. 500 nm SiO₂ einem TEOS-Verfahren abgeschieden und durch chemisch-mechanisches Polieren abgetragen, bis die zweite Hilfsschicht H2a freigelegt wird. Durch Rückätzen von SiO₂ mit z.B. CHF₃+O₂ werden in den zweiten Gräben G2a Bodenstrukturen Ba erzeugt, die in den zweiten Gräben ebene Böden bilden (s. Fig 4a und 4b). Die ebenen Böden liegen ca. 500 nm unterhalb der Oberfläche Oa und damit knapp unterhalb der Oberkante der zweiten Source/Drain-Gebiete S/D2a. Das teilweise Tieferätzen der zweiten Gräben G2a vergrößert die vertikale Toleranz für die Höhe der ebenen Böden der zweiten Gräben G2 (s. Fig. 4a).

Anschließend wird mit Hilfe einer ersten Photolackmaske Pm1, die jedes zweite zwischen zwei benachbarten ersten Gräben G1 liegende Gebiet bedeckt, an Teilen von zweiten Flanken 2F2a der zweiten Gräben G2a durch schräge Implantation Channel-Stop-Gebiete Ca erzeugt (s. Fig. 5). Mit Hilfe einer zweiten Photolackmaske Pm2, die Gebiete, die die erste Photolackmaske Pm1 abdeckte, nicht bedeckt, werden durch schräge Implantation an ersten Flanken 2F1a der zweiten Gräben G2a Channel-Stop-Gebiete Ca erzeugt (s. Fig. 5). Die Dotierstoffkonzentration der Channel-Stop-Gebiete Ca beträgt ca. 1x10¹⁹ cm⁻³.

Durch thermische Oxidation wird ein ca. 10 nm dickes Gatedielektrikum Gda erzeugt (s. Fig. 6). Zur Erzeugung von Wortleitungen Wla wird n-dotiertes Polysilizium in einer Dicke von ca.150 nm abgeschieden. Anschließend wird Polysilizium mit z.B. C₂F₆+O₂ geätzt, bis ein Teil des Gatedielektrikums Gda, das an der zweiten Hilfsschicht H2a angrenzt, freigelegt wird. Durch isotropes Ätzen von SiO₂ mit z.B. HF werden die freiliegenden Teile des Gatedielektrikums Gda entfernt. Anschließend wird Polysilizium geätzt, bis an den ersten Flanken 2F1a der zweiten Gräben G2a und an den zweiten Flanken 2F2a der zweiten Gräben G2a Wortleitungen Wla in Form von Spacern entstehen. Teile der Wortleitungen Wla, die an die ersten Source/Drain-Gebiete S/D1a angrenzen, sind als Gateelektroden Gaa geeignet (s. Fig. 6).

Anschließend wird SiO₂ in einer Dicke von ca. 500 nm abgeschieden und durch chemisch-mechanisches Polieren planarisiert. Dadurch entsteht eine zweite isolierende Struktur I2a (s. Fig. 6).

Mit Hilfe einer Photolackmaske wird SiO₂ geätzt, bis Teile der ersten Source/Drain-Gebiete S/D1a freigelegt werden. Durch Abscheiden von ca. 400 nm Wolfram und Rückätzen mit z.B. SF₆, bis die zweite isolierende Struktur I2a freigelegt wird, werden Kontakte Ka für die ersten Source/Drain-Gebiete S/D1a erzeugt (s. Fig. 6).

Anschließend wird Platin in einer Dicke von ca. 200 nm abgeschieden. Zur Erzeugung von ersten Kondensatorplatten P1a wird mit Hilfe einer Photolackmaske, die die Kontakte Ka abdeckt, Platin mit z.B. Cl₂+O₂ geätzt, bis die zweite isolierende Struktur I2a freigelegt wird. Anschließend wird Ba_{0.5}Sr_{0.5}TiO₃ in einer Dicke von ca. 20 nm abgeschieden, wodurch ein Kondensatordielektrikum Kda erzeugt wird. Durch Abscheiden von ca. 300 nm Platin wird eine zweite Kondensatorplatte P2a erzeugt (s. Fig. 6).

In einem zweiten Ausführungsbeispiel werden analog wie im ersten Ausführungsbeispiel mit einer ersten Maske M1b in einem zweiten Substrat 1b, das eine Schicht SKb für Kanalgebiete Kab und eine Schicht SSb für erste Source/Drain-Gebiete S/D1b umfaßt, erste Gräben G1b erzeugt (s. Fig. 7). Die ersten Gräben G1b sind im Gegensatz zum ersten Ausführungsbeispiel ca. 2 µm tief. Zur Erzeugung von Bitleitungen Blb an Böden der ersten Gräben G1b wird hoch n-dotiertes Polysilizium in einer Dicke von ca. 400 nm abgeschieden, durch chemisch-mechanisches Polieren planarisiert, bis die erste Maske M1b freigelegt wird, und ca. 1,2 µm tief zurückgeätzt. Die Bitleitungen Blb sind dadurch ca. 1 µm dick. Zur elektrischen Isolierung der Bitleitungen Blb vom Substrat 1b wird durch Tempern Dotierstoff der Bitleitungen Blb in das Substrat 1b ausdiffundiert, wodurch zweite Diffusionsgebiete D2b entstehen (s. Fig. 7).

Zur Erzeugung von ersten isolierenden Strukturen (nicht dargestellt), wird wie im ersten Ausführungsbeispiel SiO₂ in einer Dicke von ca. 500 nm in einem TEOS-Verfahren abgeschieden und durch chemisch-mechanisches Polieren planarisiert, bis die Schicht SSb für die ersten Source/Drain-Gebiet S/D1b freigelegt wird.

Wie im ersten Ausführungsbeispiel werden eine erste Hilfsschicht (nicht dargestellt), eine zweite Hilfsschicht (nicht dargestellt), eine dritte Hilfsschicht (nicht dargestellt), zweite Gräben G2b, erste Source/Drain-Gebiete S/D1b und Kanalgebiete Kab erzeugt. Anders als im ersten Ausführungsbeispiel beträgt der Abstand zwischen Mittellinien zweier benachbarter zweiter Gräben G2b ca. 1 µm. Wie im ersten Ausführungsbeispiel werden zweite Source/Drain-Gebiete S/D2b, erste Diffusionsgebiete (nicht dargestellt), Bodenstrukturen Bb für die zweiten Gräben G2b, Channel-Stop-Gebiete Cb, erste isolierende Strukturen (nicht dargestellt) und ein Gate-Dieleketrikum Gdb erzeugt. Anschließend wird n-dotiertes Polysilizium in einer Dicke von ca. 150 nm abgeschieden, und durch chemisch-mechanisches Polieren planarisiert, bis Teile des Gatedielektrikums Gdb, die an die zweite Hilfsschicht H2b angrenzen, freigelegt werden. Anschließend wird Polysilizium geätzt, bis die Wortleitungen Wlb und damit die Gateelektroden Gab in Form von Spacern an Flanken der zweiten Gräben G2b entstehen. Die Wortleitungen Wlb grenzen nicht an die zweite Hilfsschicht H2b an. Anschließend wird SiO₂ in einer Dicke von ca. 500 nm abgeschieden und durch chemisch-mechanisches Polieren planarisiert, bis die zweite Hilfsschicht H2b freigelegt wird. Dadurch entsteht eine zweite isolierende Struktur I2b. Durch Ätzen von Polysilizium selektiv zu SiO₂ mit z. B. C₂F₆+O₂ wird die zweite Hilfsschicht H2b entfernt. Anschießend wird SiO₂ mit z. B. CHF₃+O₂ geätzt, bis die ersten Source/Drain-Gebiete S/D1b freigelegt werden und die erste Hilfsschicht H1b entfernt wird. Eine Oberkante der zweiten isolierenden Struktur I2b liegt höher als die ersten Source/Drain-Gebiete S/D1b. Durch Abscheiden von n-dotiertem Polysilizium in einer Dicke von ca. 500 nm und anschließendem chemisch-mechanischem Polieren bis die zweite isolierende Struktur I2b freigelegt wird, entstehen selbstjustiert Kontakte Kb zu den ersten Source/Drain-Gebieten S/D1b. Anschließend werden analog im ersten Ausführungsbeispiel erste Kondensatorplatten P1b, ein Kondensatordielektrikum Kdb und eine zweite Kondensatorplatte P2b erzeugt (s. Fig. 8).

In einem dritten Ausführungsbeispiel werden analog wie im ersten Ausführungsbeispiel in einem dritten Substrat 1c, das eine Schicht SKc für Kanalgebiete Kac und eine Schicht SSc für erste Source/Drain-Gebiete S/D1c umfaßt, mit Hilfe einer ersten Maske M1c ca. 2 µm tiefe erste Gräben G1c erzeugt (s. Fig. 9). Zur Erzeugung einer dritten isolierenden Struktur I3c wird SiO₂ in einer Dicke von ca. 50 nm abgeschieden. Anschließend wird Wolframsilizid in einer Dicke von ca. 400 nm abgeschieden, durch chemisch-mechanisches Polieren planarisiert, bis die erste Maske M1c freigelegt wird, und dann ca. 1,2 µm tief geätzt. Als Ätzmittel ist z.B. SF₆ geeignet. Dadurch entstehen Bitleitungen Blc. Die Bitleitungen Blc werden durch die dritte isolierende Struktur I3c vom Substrat 1c isoliert (s. Fig. 9). Anschließend werden freiliegende Teile der dritten isolierenden Struktur I3c mit z.B. HF entfernt.

Zur Erzeugung von ersten isolierenden Strukturen I1c wird wie im ersten Ausführungsbeispiel SiO₂ in einer Dicke von ca. 500 nm abgeschieden und durch chemisch-mechanisches Polieren planarisiert, bis die ersten Source/Drain-Gebiete S/D1c freigelegt werden.

Durch Abscheiden von SiO₂ in einer Dicke von ca. 100 nm wird eine erste Hilfsschicht H1c erzeugt. Durch Abscheiden von Polysilizium in einer Dicke von ca. 100 um wird eine zweite Hilfsschicht H2c erzeugt. Durch Abscheiden von SiO₂ in einer Dicke von ca. 100 nm wird eine sechste Hilfsschicht H6c erzeugt. Durch Abscheiden von Polysilizium in einer Dicke von ca. 100 nm wird eine siebte Hilfsschicht H7c erzeugt. Durch Abscheiden von SiO₂ in einer Dicke von 100 nm wird eine dritte Hilfsschicht H3c erzeugt (s. Fig. 10). Mit Hilfe einer Photolackmaske werden die dritte Hilfsschicht H3c, die siebte Hilfsschicht H7c, die sechste Hilfsschicht H6c, die zweite Hilfsschicht H2c und die erste Hilfsschicht H1c strukturiert. Die dritte Hilfsschicht H3c dient anschließend als Maske bei der Erzeugung von zweiten Gräben G2c. Dazu wird Silizium selektiv zu SiO₂ mit z.B. HBr+NF₃+He+O₂ ca. 500 um tief geätzt.

Analog wie im ersten Ausführungsbeispiel werden durch Abscheiden von SiO₂ in einer Dicke von ca. 500 nm und Rückätzen an Flanken der zweiten Gräben G2c zweite Spacer Sp2c erzeugt. Durch Implantation und Tempern werden wie im ersten Ausführungsbeispiel an Böden der zweiten Gräben G2c zweite Source/Drain-Gebiete S/D2c erzeugt. Die zweiten Source/Drain-Gebiete S/D2c sind ca. 300 um tief. Ihre Dotierstoffkonzentration beträgt ca. 5x10²⁰ cm⁻³. Bei der Implantation schützen die zweiten Spacer Sp2c die Flanken der zweiten Gräben G2c (s. Fig. 10). Durch die Erzeugung der zweiten Gräben G2c und der ersten Gräben G1c entstehen aus der Schicht SKc für die Kanalgebiete Kac die Kanalgebiete Kac und aus der Schicht für die ersten Source/Drain-Gebiete S/D1c die ersten Source/Drain-Gebiete S/D1c. Die ersten Source/Drain-Gebiete S/D1c und die Kanalgebiete Kac sind seitlich von den ersten Gräben G1c und den zweiten Gräben G2c umgeben.

Anschließend wird wie im ersten Ausführungsbeispiel Silizium geätzt, wodurch die zweiten Gräben G2a in Gebieten außerhalb der ersten Gräben G1a ca. 200 nm tiefer werden (s. Fig. 10).

Anschließend wird SiO₂ in einer Dicke von ca. 500 nm abgeschieden und durch chemisch-mechanisches Polieren planarisiert, bis die siebte Hilfsschicht H7c freigelegt wird. Anschließend wird innerhalb der zweiten Gräben G2c in Gebieten, die teilweise mit den ersten Gräben G1c überlappen und teilweise mit den ersten Gräben G1c nicht überlappen SiO₂ geätzt, bis Teile der Bitleitungen Blc und Teile der zweiten Source/Drain-Gebiete S/D2c freigelegt werden (s. Fig. 11b). Dazu wird eine streifenförmige, parallel zu den ersten Gräben G1c verlaufende Fotolackmaske, die die ersten Gräben G1c teilweise überlappt, aufgebracht. Die siebte Hilfsschicht H7c schützt außerhalb der Fotolackmaske befindliche Teile der sechsten Hilfsschicht H6c. Zur Erzeugung von leitenden Strukturen Lc, die jeweils eine Bitleitung Blc und ein zweites Source/Drain-Gebiet S/D2c miteinander verbinden, wird n-dotiertes Polysilizium in einer Dicke von ca. 400 nm abgeschieden und durch chemisch-mechanisches Polieren planarisiert, bis die siebte Hilfsschicht H7c entfernt und die sechste Hilfsschicht H6c freigelegt wird. Anschließend wird ca. 0.9 µm tief rückgeätzt. Dadurch entsteht eine Struktur Pl aus Polysilizium (s. Fig. 11 a und Fig. 11 b). Die sechte Hilfsschicht H6c dient dabei als Maske und schützt die zweite Hilfsschicht H2c. Als Ätzmittel ist z.B. C₂F₆+O₂ geeignet. Durch Tempern wird Dotierstoff der Struktur Pl aus Polysilizium in das Substrat 1c ausdiffundiert. Dadurch entstehen erste Diffusionsgebiete D1c, die die Struktur Pl aus Polysilizium elektrisch vom Substrat 1c isoliert. Jeweils eine Struktur Pl aus Polysilizium und ein zugehöriges erstes Diffusionsgebiet D1c bilden zusammen die leitende Struktur Lc (s. Fig. 11 b).

Anschließend wird SiO₂ in einer Dicke von ca. 500 nm abgeschieden und durch chemisch-mechanisches Polieren planarisiert, bis die zweite Hilfsschicht H2c freigelegt wird. Dabei wird die sechste Hilfsschicht H6c entfernt. Anschließend wird SiO₂ ca. 700 nm tief geätzt, wodurch Bodenstrukturen Bc, die in den zweiten Gräben G2c ebene Böden der zweiten Gräben G2c bilden (s. Fig. 12 a), erzeugt werden. Anschließend werden analog wie im ersten Ausführungsbeispiel Channel-Stop-Gebiete Cc, ein Gatedielektrikum Gdc, Wortleitungen Wlc, Gateelektroden Gac, eine zweite isolierende Struktur I2c, Kontakte Kc, erste Kondensatorplatten P1c, ein Kondensatordielektrikum Kdc und eine zweite Kondensatorplatte P2c erzeugt (s. Fig. 12 a und 12 b).

In einem vierten Ausführungsbeispiel ist ein viertes Substrat 1d p-dotiert. Die Dotierstoffkonzentration des vierten Substrats 1d beträgt ca. 10¹⁵ cm⁻³. Durch Epitaxie wird eine ca. 500 nm dicke n-dotierte Schicht SBd für Bitleitungen Bld erzeugt. Die Dotierstoffkonzentration der Schicht SBd für die Bitleitungen Bld beträgt ca. 5x10²⁰ cm⁻³. Darüber wird durch EPitaxie eine ca. 300 nm dicke p-dotierte Schicht SKd für Kanalgebiete Kad erzeugt. Die Dotierstoffkonzentration der Schicht SKd für Kanalgebiete Kad beträgt ca. 3x10¹⁷ cm⁻³. Darüber wird durch Epitaxie eine ca. 150 nm dicke n-dotierte Schicht SSd für erste Source/Drain-Gebiete S/D1d erzeugt. Die Dotierstoffkonzentration der Schicht SSd für die ersten Source/Drain-Gebiete S/D1d beträgt ca. 5x10²⁰ cm⁻³ (s. Fig. 13).

Zur Erzeugung einer ersten Maske (nicht dargestellt) wird SiO₂ in einer Dicke von ca. 200 nm in einem TEOS-Verfahren abgeschieden und durch ein photolithographisches Verfahren strukturiert. Erste Gräben G1d entstehen mit Hilfe der ersten Maske durch Ätzen von Silizium selektiv zu SiO₂. Der Abstand zwischen Mittellinien benachbarter erster Gräben G1d beträgt ca. 1 µm. Die ersten Gräben G1d durchtrennen die Schicht SBd für die Bitleitungen Bld. Dadurch entstehen aus der Schicht SBd für die Bitleitungen Bld die Bitleitungen Bld.

Anschließend werden analog zum ersten Ausführungsbeispiel erste isolierende Strukturen I1d erzeugt. Die ersten isolierenden Strukturen I1d isolieren benachbarte Bitleitungen Bld voneinander.

Eine dritte Hilfsschicht H3d aus SiO₂ wird abgeschieden, zusammen mit der ersten isolierenden Struktur I1d durch ein fotolithografisches Verfahren strukturiert und anschließend als zweite Maske beim Ätzen vom Silizium zur Erzeugung von zweiten Gräben G2d verwendet. Zweite Source/Drain-Gebiete S/D2d sind Teile der Bitleitungen Bld und müssen nicht wie in den vorangegangenen Ausführungsbeispielen an Böden der zweiten Gräben G2d hergestellt werden. Die zweiten Gräben G2d reichen bis knapp unterhalb der Schicht SKd für die Kanalgebiete Kad und sind ca. 500nm tief. Durch die Erzeugung der zweiten Gräben G2d und der ersten Gräben G1d entstehen aus der Schicht SKd für die Kanalgebiete Kad die Kanalgebiete Kad und aus der Schicht für die ersten Source/Drain-Gebiete S/D1d die ersten Source/Drain-Gebiete S/D1d. Die ersten Source/Drain-Gebiete S/D1d und die Kanalgebiete Kad sind seitlich von den ersten Gräben G1d und den zweiten Gräben G2d umgeben.

Anschließend werden ohne Maske durch schräge Implantation an zweiten Flanken 2F2d der zweiten Gräben G2d Channel-Stop-Gebiete Cd erzeugt.

Durch thermische Oxidation wird ein Gatedielektrikum Gdd erzeugt. Auch nach der Erzeugung des Gatedielektrikums Gdd sind Böden der zweiten Gräben G2d im wesentlichen eben.

Anschließend wird n-dotiertes Polysilizium in einer Dicke von ca. 400 nm abgeschieden und durch chemisch-mechanisches Polieren planarisiert, bis die dritte Hilfsschicht H3d freigelegt wird. Anschließend wird Polysilizium geätzt, wodurch in jedem zweiten Graben G2d eine Wortleitung Wld und als Teil der Wortleitung Wld Gateelektroden Gad entstehen.

Anschließend wird zur Erzeugung einer zweiten isolierenden Struktur I2d, SiO₂ in einer Dicke von ca. 500 nm abgeschieden und durch chemisch-mechanisches Polieren planarisiert. Mit Hilfe einer Maske, die Teile der ersten Source/Drain-Gebiete S/D1d nicht bedeckt, wird SiO₂ geätzt, bis die Teile der ersten Source/Drain-Gebiete S/D1d freigelegt werden. Durch Abscheiden von Wolfram in einer Dicke von ca. 400 nm und Ätzen mit z. B. SF₆, bis die zweite isolierende Struktur I2d freigelegt wird, werden Kontakte Kd erzeugt.

Analog wie im ersten Ausführungsbeispiel werden erste Kondensatorplatten P1d, ein Kondensatordielektrikum Kdd und eine zweite Kondensatorplatte P2d erzeugt (s. Fig. 15 a und 15 b).

In einem fünften Ausführungsbeispiel ist ein fünftes Substrat 1e in einer an eine Oberfläche Oe des fünften Substrats 1e angrenzenden Schicht S n-dotiert. Die Dotierstoffkonzentration der Schicht S beträgt ca. 10²⁰ cm⁻³. Durch Epitaxie wird eine p-dotierte Schicht SKe für Kanalgebiete Kae erzeugt. Die Dotierstoffkonzentration der Schicht SKe für Kanalgebiete Kae beträgt ca. 10¹⁷ cm⁻³ (s. Fig. 16). Durch ein photolithographisches Verfahren werden durch Implantation n-dotierte streifenförmige zueinander parallel verlaufende Gebiete Ge für zweite Source/Drain-Gebiete S/D2e erzeugt. Die Dotierstoffkonzentration der Gebiete Ge beträgt ca. 5x10²⁰ cm⁻³. Die Gebiete Ge sind ca. 150 nm tief (s. Fig. 16).

Durch Abscheiden von SiO₂ in einer Dicke von ca. 150 nm wird eine vierte Hilfsschicht H4e erzeugt. Durch Abscheiden von Polysilizium in einer Dicke von ca. 150 nm wird eine fünfte Hilfsschicht (nicht dargestellt) erzeugt. Durch Abscheiden von SiO₂ in einer Dicke von ca. 150 nm wird eine dritte Hilfsschicht (nicht dargestellt) erzeugt (s. Fig. 17). Durch ein photolithographisches Verfahren werden die dritte Hilfsschicht, die fünfte Hilfsschicht und die vierte Hilfsschicht H4e strukturiert. Durch Ätzen von Silizium selektiv zu SiO₂ werden quer zu den Gebieten Ge und zueinander parallel verlaufende zweite Gräben G2e erzeugt, wobei die strukturierte dritte Hilfsschicht als Maske dient. Der Abstand zwischen Mittellinien zweier benachbarter zweiter Gräben beträgt ca. 1 µm. Die zweiten Gräben G2e sind ca. 600 nm tief. Als Ätzmittel ist z. B. HBrF geeignet. Anschließend wird SiO₂ geätzt, bis die drittete Hilfsschicht entfernt wird.

Anschließend werden wie im ersten Ausführungsbeispiel Channel-Stop-Gebiete Ce erzeugt, wobei den ersten Gräben G1a zwischen den Gebieten Ge liegende Bereiche entsprechen. Durch Abscheiden von SiO₂ in einer Dicke von ca. 500 nm und chemisch-mechanischem Polieren, bis die fünfte Hilfsschicht freigelegt wird, werden die zweiten Gräben G2e mit SiO₂ aufgefüllt.

Mit Hilfe einer Photolackmaske, die die Gebiete Ge nicht bedeckt, wird SiO₂ geätzt, wodurch in Teilen der zweiten Gräben G2e Vertiefungen entstehen, in denen das SiO₂ entfernt wurde. Die fünfte Hilfsschicht schützt dabei die vierte Hilfsschicht H4e.

Zur Erzeugung von zweiten Spacern Sp2e wird SiO₂ in einer Dicke von ca. 50 nm abgeschieden und rückgeätzt. Anschließend werden durch Implantation an Böden der zweiten Gräben G2e erste Source/Drain-Gebiete S/D1e erzeugt. Die zweiten Spacer Sp2e schützen Flanken der zweiten Gräben G2e bei der Implantation. Die Dotierstoffkonzentration der ersten Source/Drain-Gebiete S/D1e beträgt ca. 5x10²⁰ cm⁻³. Die ersten Source/Drain-Gebiete S/D1e sind ca. 300 nm tief. Der Dotierstoff wird durch Tempern aktiviert (s. Fig. 17).

Anschließend wird Silizium selektiv zu SiO₂ geätzt, wodurch die fünfte Hilfsschicht entfernt wird und die Vertiefungen ca. 10 µm tiefer werden. Zur Erzeugung eines Kondensatordielektrikums Kde wird eine ca. 9nm dicke ONO-Schicht gebildet. Dazu wird zunächst durch thermische Oxidation ca. 3nm SiO₂ aufgewachsen und dann ca. 6 nm Siliziumnitrid abgeschieden, das anschließend durch thermische Oxidation ca. 3nm tief aufoxidiert wird. Anschließend wird dotiertes Polysilizium in einer Dicke von ca. 300 nm abgeschieden und durch chemisch-mechanisches Polieren planarisiert, bis die vierte Hilfsschicht H4e freigelegt wird. Anschließend wird Polysilizium selektiv zu SiO₂ ca. 1150 nm tief geätzt. Dadurch entstehen Speicherknoten Sp von Kondensatoren. Durch isotropes Ätzen mit z.B. CF₄-Plasma werden freiliegende Teile des Kondensatordielektrikums Kde entfernt (s. Fig. 17). Zur Erzeugung von Verbindungselementen Ve, die die Speicherknoten Sp mit den ersten Source/Drain-Gebieten S/D1e elektrisch verbinden, wird Polysilizium in einer Dicke von ca. 300 nm abgeschieden und durch chemisch-mechanisches Polieren planarisiert, bis die vierte Hilfsschicht H4e freigelegt wird. Anschließend wird Polysilizium zurückgeätzt` bis die Verbindungselemente Ve, die als Teile der Speicherknoten Sp betrachtet werden können, entstehen. Anschließend wird SiO₂ geätzt, bis die zweiten Spacer Sp2e und die vierte Hilfsschicht H4e entfernt werden. Als Ätzmittel ist z. B. HF geeignet. Durch thermische Oxidation wird ein ca. 10 nm dickes Gatedielektrikum Gde aufgewachsen. Zur Erzeugung von Wortleitungen Wle und von Gateelektroden Gae wird Polysilizium in einer Dicke von ca. 150 nm abgeschieden und rückgeätzt, bis die Wortleitungen Wle und damit die Gateelektroden Gae in Form von Spacern an Flanken der zweiten Gräben G2e entstehen. Die Wortleitungen Wle liegen tiefer als die Oberfläche Oe. Zur Erzeugung einer zweiten isolierenden Struktur I2e wird SiO₂ in einer Dicke von ca. 500 nm abgeschieden und durch chemisch-mechanisches Polieren planarisiert, bis die zweiten Source/Drain-Gebiete S/D2e freigelegt werden. Anschließend wird Wolfram in einer Dicke von ca. 500 nm abgeschieden und durch ein photolithographisches Verfahren strukturiert. Dadurch entstehen Bitleitungen Ble, die streifenförmig sind, parallel zueinander verlaufen, senkrecht zu den Wortleitungen Wle verlaufen und an die zweiten Source/Drain-Gebiete S/D2e angrenzen (s. Fig. 18).

Es sind viele Variationen der fünf Ausführungsbeispiele denkbar, die ebenfalls im Rahmen der Erfindung liegen. Insbesondere können die Abmessungen der vorgestellten Schichten, Gebiete und Gräben nach Belieben an die jeweiligen Erfordernisse angepaßt werden. Dasselbe gilt auch für die vorgeschlagenen Dotierstoffkonzentrationen. Statt chemischmechanisch zu polieren kann auch rückgeätzt werden. Leitfähigkeitstypen können vertauscht werden. Als Material für die Kontakte sind auch andere leitende Materialien geeignet. Statt thermischer Oxidation kann auch ein TEOS-Verfahren angewendet werden. Statt Borsilikatglas können auch z.B. Phosphorsilikatglas oder Borphosphorsilikatglas verwendet werden. Statt Wolfram können auch z.B. AlSiCu, Kupfer oder Aluminium verwendet werden.

Wie im vierten Ausführungsbeispiel kann in den Ausführungsbeispielen 1 bis 3 auf die Bodenstrukturen der zweiten Gräben G2d verzichtet werden. Auf eine zusätzliche Vertiefung von Teilen der zweiten Gräben kann dann auch verzichtet werden. Umgekehrt können im vierten Ausführungsbeispiel Bodenstrukturen erzeugt werden. Um eine angemessene vertikale Toleranz für die Einstellung der Höhe der Bodenstrukturen zu erhalten, können die zweiten Gräben z.B. 200nm tiefer geätzt werden.

Die ersten Source/Drain-Gebiete aus dem Ausführungsbeispiel 2 können auch durch Kontakte, die durch maskiertes Ätzen erzeugt werden (Ausführungsbeispiele 1, 3 und 4), oder ohne Kontakte (Ausführungsbeispiel 5) mit den ersten Kondensatorplatten verbunden werden. Die ersten Source/Drain-Gebiete aus den Ausführungsbeispielen 1, 3 und 4 können auch durch selbstjustierte Kontakte (Ausführungsbeispiel 2) oder ohne Kontakte (Ausführungsbeispiel 5) mit den ersten Kondensatorplatten verbunden werden. Die ersten Source/Drain-Gebiete aus dem Ausführungsbeispiel 5 können auch durch selbstjustierte Kontakte (Ausführungsbeispiel 2) oder durch Kontakte, die durch maskiertes Ätzen erzeugt werden (Ausführungsbeispiele 1, 3 und 4), mit den Bitleitungen verbunden werden.

## Patentansprüche

1. DRAM-Zellenanordnung,
- mit Speicherzellen, die jeweils einen als vertikalen MOS-Transistor ausgebildeten Auswahltransistor und einen Speicherkondensator umfassen,
- bei der eine Halbleiterstruktur zwei sich gegenüberliegende Flanken aufweist,
- bei der die Halbleiterstruktur mindestens eines von zwei Source/Drain-Gebieten (S/D1a) und ein darunter angeordnetes Kanalgebiet (Kaa) des Auswahltransistors umfaßt,
- bei der das Source/Drain-Gebiet (S/D1a) an die zwei Flanken der Halbleiterstruktur angrenzt,
- bei der das Kanalgebiet (Kaa) an eine der zwei Flanken der Halbleiterstruktur angrenzt, an die ein Gatedielektrikum (Gda) angrenzt,
- bei der eine Gateelektrode (Gaa), die mit einer ersten Wortleitung (Wla) verbunden ist, an das Gatedielektrikum (Gda) angrenzt,
- bei der an einer anderen der zwei Flanken der Halbleiterstruktur in einer Höhe des Kanalgebiets (Kaa) des Auswahltransistors ein Element, das die Ausbildung eines Kanals verhindert, angeordnet ist,
- bei der eine zweite Wortleitung (Wla) neben dem Element, das die Ausbildung eines Kanals verhindert, und außerhalb der Halbleiterstruktur angeordnet ist,
- bei der ein erstes der Source/Drain-Gebiete (S/D1a) mit dem Speicherkondensator verbunden ist,
- bei der ein zweites der Source/Drain-Gebiete (S/D2a) mit einer Bitleitung (Bla), die quer zu den Wortleitungen (Wla) verläuft, verbunden ist.

2. DRAM-Zellenanordnung nach Anspruch 1,
- bei der das Element, das die Ausbildung eines Kanals verhindert, ein Channel-Stop-Gebiet (Ca) ist.

3. DRAM-Zellenanordnung nach Anspruch 1 oder 2,
- bei der das zweite Source/Drain-Gebiet (S/D2e) bezüglich einer Achse (A), die senkrecht zu einer Oberfläche (Oe) eines Substrats (1e) verläuft, oberhalb des ersten Source/Drain-Gebiets (S/D1e) angeordnet ist,
- bei der der Speicherkondensator innerhalb des Substrats (1e) angeordnet ist.

4. DRAM-Zellenanordnung nach Anspruch 1 oder 2,
- bei der das erste Source/Drain-Gebiet (S/D1d) bezüglich einer Achse (A), die senkrecht zu einer Oberfläche (Od) eines Substrats (1d) verläuft, oberhalb des zweiten Source/Drain-Gebiets (S/D2d) angeordnet ist,
- bei der das zweite Source/Drain-Gebiet (S/D2d) Teil der Bitleitung (Bld) ist,
- bei der benachbarte Bitleitungen (Bld) durch eine erste isolierende Struktur (I1d) voneinander getrennt sind.

5. DRAM-Zellenanordnung nach Anspruch 1 oder 2,
- bei der die Bitleitung bezüglich einer Achse (A), die senkrecht zu einer Oberfläche (Oa) eines Substrats (1a) verläuft, unterhalb von und lateral zu dem zweiten Source/Drain-Gebiets (S/D2a) angeordnet ist,
- bei der die Bitleitung (Bla) über eine leitende Struktur mit dem zweiten Source/Drain-Gebiet (S/D2a) verbunden ist,
- bei der das Kanalgebiet (Kaa) über dem zweiten Source/Drain-Gebiet (S/D2a) und das erste Source/Drain-Gebiet (S/D1a) über dem Kanalgebiet (Kaa) angeordnet ist.

6. DRAM-Zellenanordnung nach Anspruch 5,
- bei der ein zweites Diffusionsgebiet (D2b) die Bitleitung (Blb) umgibt,
- bei der das Substrat (1b) von einem ersten Leitfähigkeitstyp dotiert ist,
- bei der das zweite Diffusionsgebiet (D2b) von einem zweiten, zum ersten Leitfähigkeitstyp entgegengesetzten Leitfähigkeitstyp dotiert ist,
- bei der die leitende Struktur ein erstes Diffusionsgebiet umfaßt.

7. DRAM-Zellenanordnung nach Anspruch 5,
- bei der die Bitleitung (Blc) durch eine dritte isolierende Struktur (I3c) vom Substrat (1c) elektrisch isoliert wird,
- bei der die leitende Struktur (Lc) dotiertes Polysilizium und ein erstes Diffusionsgebiet (D1c) umfaßt.

8. DRAM Zellenanordnung nach Anspruch 5,
- bei der die Bitleitung (Bla) als ein von einem zweiten Leitfähigkeitstyp dotiertes Gebiet innerhalb des Substrats (1a), das von einem ersten, zum zweiten Leitfähigkeitstyp entgegengesetzten Leitfähigkeitstyp dotiert ist, angeordnet ist,
- bei der die leitende Struktur ein erstes Diffusionsgebiet (D1a) umfaßt.

9. DRAM-Zellenanordnung nach einem der Ansprüche 1 bis 8,
- mit folded Bitleitungen (Bla),
- bei der Wortleitungen (Wla) und Bitleitungen (Bla) im wesentlichen gerade verlaufen,
- bei der entlang zweiter Gräben (G2a) jeweils zwei der Wortleitungen (Wla) verlaufen,
- bei der erste Flanken von entlang einer der Wortleitungen (Wla) benachbarten Halbleiterstrukturen von Speicherzellen mit einer ersten Flanke (2F1a) eines der zweiten Gräben (G2a) zusammenfallen,
- bei der zweite Flanken der entlang der Wortleitung (Wla) benachbarten Halbleiterstrukturen der Speicherzellen mit einer zweiten Flanke (2F2a) eines benachbarten zweiten Grabens (G2a) zusammenfallen,
- bei der die Elemente, die die Ausbildung von Kanälen verhindern, von Speicherzellen, die entlang der Wortleitung (Wla) zueinander benachbart sind, alternierend an der ersten Flanke (2F1a) des zweiten Grabens (G2a) und an der zweiten Flanke (2F2a) des benachbarten zweiten Grabens (G2a) angeordnet sind,
- bei der Gateelektroden (Gaa) von Auswahltransistoren von jeder zweiten von entlang der Wortleitung (Wla) benachbarten Speicherzellen mit der Wortleitung (Wla) verbunden sind,
- bei der die Gateelektroden (Gaa) Teile der Wortleitungen (Wla) sind.

10. DRAM-Zellenanordnung nach Anspruch 9,
- bei der Elemente, die die Ausbildung von Kanälen verhindern, von entlang der Bitleitung (Bla) benachbarten Speicherzellen, entweder alle an ersten Flanken (2F1a) oder alle an zweiten Flanken (2F2a) zweiter Gräben (G2a) angeordnet sind.

11. DRAM-Zellenanordnung nach einem der Ansprüche 1 bis 8,
- bei der Wortleitungen (Wld) und Bitleitungen (Bld) im wesentlichen gerade verlaufen,
- bei der entlang zweiter Gräben (G2d) jeweils eine Wortleitung (Wld) verläuft,
- bei der erste Flanken von entlang einer Wortleitung (Wld) benachbarten Halbleiterstrukturen von Speicherzellen mit einer ersten Flanke eines zweiten Grabens (G2d) zusammenfallen,
- bei der zweite Flanken der entlang der Wortleitung (Wld) benachbarten Halbleiterstrukturen von Speicherzellen mit einer zweiten Flanke (2F2d) eines anderen zweiten Grabens (G2d) zusammenfallen,
- bei der Elemente, die die Ausbildung von Kanälen verhindern, von entlang der Bitleitung (Bld) benachbarten Speicherzellen, entweder alle an ersten Flanken oder alle an zweiten Flanken (2F2d) zweiter Gräben (G2d) angeordnet sind,
- bei der Gateelektroden (Gad) von Auswahltransistoren von entlang der Wortleitung (Wld) benachbarten Speicherzellen mit der Wortleitung (Wld) verbunden sind,
- bei der die Gateelektroden (Gad) Teile der Wortleitungen (Wld) sind.

12. DRAM-Zellenanordnung nach Anspruch 11,
- bei der Elemente, die die Ausbildung von Kanälen verhindern, von Speicherzellen, entweder alle an ersten Flanken oder alle an zweiten Flanken (2F2d) zweiter Gräben (G2d) angeordnet sind.

13. Verfahren zur Herstellung einer DRAM-Zellenanordnung,
- bei dem parallel zueinander verlaufende zweite Gräben (G2a) in einem Substrat (1a) erzeugt werden, so daß zwischen zwei der zweiten Gräben (G2a) eine Halbleiterstruktur erzeugt wird, die mindestens eines von zwei Source/Drain-Gebieten (S/D1a) und ein darunter angeordnetes Kanalgebiet (Kaa) eines vertikalen Auswahltransistors umfaßt, wobei das Source/Drain-Gebiet (S/D1a) an zwei sich gegenüberliegende, durch die zweiten Gräben (G2a) gebildete Flanken der Halbleiterstruktur angrenzt,
- bei dem in der Halbleiterstruktur in einer Höhe des Kanalgebiets (Kaa) ein Channel-Stop-Gebiet (Ca) erzeugt wird, indem eine der zwei Flanken der Halbleiterstruktur maskiert wird, und eine andere der zwei Flanken schräg implantiert wird,
- bei dem die zwei Flanken der Halbleiterstruktur mit einem Gatedielektrikum (Gda) versehen werden,
- bei dem in den zweiten Gräben (G2a) Wortleitungen (Wla) erzeugt werden,
- bei dem ein Speicherkondensator erzeugt wird, der mit einem ersten der zwei Source/Drain-Gebiete (S/D1a) verbunden wird,
- bei dem eine quer zu den Wortleitungen (Wla) verlaufende Bitleitung (Bla) erzeugt wird, die mit einem zweiten der zwei Source/Drain-Gebiete (S/D2a) verbunden wird.

14. Verfahren nach Anspruch 13,
- bei dem die Wortleitungen (Wla) erzeugt werden, indem nach Erzeugung der zweiten Gräben (G2a) leitendes Material abgeschieden und rückgeätzt wird, bis in den zweiten Gräben (G2a) jeweils zwei Wortleitungen (Wla) in Form von Spacern erzeugt werden,
- bei dem Channel-Stop-Gebiete (Ca) von entlang einer der Wortleitungen (Wla) benachbarten Speicherzellen, alternierend angrenzend an eine erste Flanke (2F1a) des zweiten Grabens (G2a), in der die Wortleitung (Wla) angeordnet ist, und an eine zweite Flanke (2F2a) eines benachbarten der zweiten Gräben (G2a) gebildet werden.

15. Verfahren nach Anspruch 13,
- bei dem die Wortleitungen (Wla) erzeugt werden, indem die zweiten Gräben (G2d) mit leitendem Material gefüllt werden,
- bei dem Channel-Stop-Gebiete (Ca) von entlang der Bitleitung (Bld) benachbarten Speicherzellen, entweder alle angrenzend an erste Flanken oder alle an zweite Flanken (2F2d) zweiter Gräben (G2d) gebildet werden.

16. Verfahren nach einem der Ansprüche 13 bis 15,
- bei dem über den Source/Drain-Gebieten (S/D1b), unter denen die Kanalgebiete (Kab) angeordnet sind, eine erste Hilfsschicht (H1b) aus isolierendem Material und eine zweite Hilfsschicht (H2b) aus Halbleitermaterial erzeugt werden,
- bei dem Kontakte (Kb) zu den Source/Drain-Gebieten (S/D1b) selbstjustiert erzeugt werden, indem nach Erzeugung der Wortleitungen (Wlb)
a) eine zweite isolierende Struktur (I2b) erzeugt wird, indem isolierendes Material abgeschieden und planarisiert wird, bis die zweite Hilfsschicht (H2b) freigelegt wird,
b) die zweite Hilfsschicht (H2b) entfernt wird, indem Halbleitermaterial selektiv zum isolierenden Material geätzt wird,
c) das isolierende Material geätzt wird, bis die erste Hilfsschicht (H1b) entfernt wird und die erste Source/Drain-Gebiete (S/D1b) oder die zweite Source/Drain-Gebiete (S/D2e) freigelegt werden,
d) leitendes Material abgeschieden und geätzt wird, wodurch die Kontakte (Kb) entstehen.

17. Verfahren nach den Ansprüchen 13 und 16,
- bei dem in einer Schicht (SKe) für die Kanalgebiete (Kae) streifenförmige zueinander parallel laufende Gebiete (Ge) für die zweiten Source/Drain-Gebiete (S/D2e) erzeugt werden,
- bei dem oberhalb der zweiten Source/Drain-Gebiete (S/D2e) oder oberhalb der zweiten Hilfsschicht (H2e) eine vierte Hilfschicht (H4e) aus isolierendem Material, eine fünfte Hilfsschicht (H5e) aus Halbleitermaterial und eine dritte Hilfsschicht (H3e) aus isolierendem Material erzeugt werden,
- bei dem zur Erzeugung der zweiten Gräben (G2e) mindestens die dritte Hilfsschicht (H3e), die vierte Hilfsschicht (H4e), und die fünfte Hilfsschicht (H5e) strukturiert werden,
- bei dem die zweiten Gräben (G2e) erzeugt werden, indem Halbleitermaterial geätzt wird, wobei die dritte Hilfsschicht (H3e) als Maske wirkt,
- bei dem die dritte Hilfsschicht (H3e) anschließend entfernt wird,
- bei dem nach Erzeugung der Channel-Stop-Gebiete (Ce) isolierendes Material abgeschieden und planarisiert wird, bis die fünfte Hilfsschicht (H5e) freigelegt wird,
- bei dem mit Hilfe einer Maske, die die Gebiete (Ge) für die zweiten Source/Drain-Gebiete (S/D2e) nicht abdeckt, das isolierende Material teilweise entfernt wird, wobei die fünfte Hilfsschicht (H5e) die vierte Hilfsschicht (H4e) schützt,
- bei dem angrenzend an Böden der zweiten Gräben (G2e) die ersten Source/Drain-Gebiete (S/D1e) durch Implantation und Tempern erzeugt werden,
- bei dem Speicherknoten (Sp) der Kondensatoren erzeugt werden, indem Halbleitermaterial geätzt wird, ein Kondensatordielektrikum (Kde) erzeugt wird und anschließend leitendes Material abgeschieden und geätzt wird, bis die Höhe der Speicherknoten im Bereich der ersten Source/Drain-Gebiete (S/D1) liegt, wodurch die fünfte Hilfsschicht (H5e) entfernt wird und die vierte Hilfsschicht (H4e) die zweiten Source/Drain-Gebiete (S/D2e) oder die zweite Hilfsschicht (H2e) schützt,
- bei dem anschließend das Kondensatordielektrikum (Kde) teilweise entfernt wird und leitendes Material abgeschieden und rückgeätzt wird, so, daß die Speicherknoten (Sp) jeweils mit einem der ersten Source/Drain-Gebiete (S/D1e) verbunden sind,
- bei dem anschließend ein Gatedielektrikum (Gde) erzeugt wird,
- bei dem anschließend die Wortleitungen (Wle) erzeugt werden.

18. Verfahren nach einem der Ansprüche 13 bis 17,
- bei dem das erste Source/Drain-Gebiet (S/D1a) bezüglich einer Achse (A), die senkrecht zu einer Oberfläche (Oa) des Substrats (1a) verläuft, oberhalb des zweiten Source/Drain-Gebiets (S/D2a) gebildet wird,
- bei dem parallel zueinander verlaufende erste Gräben (G1a) erzeugt werden,
- bei dem die ersten Gräben (G1a) bis zu Oberkanten der ersten Gräben (G1a) zumindest teilweise mit isolierendem Material, das an die Bitleitungen (Bla) angrenzt, aufgefüllt werden,
- bei dem quer zu den ersten Gräben (G1a) die zweiten Gräben (G2a), die jeweils teilweise flacher als die ersten Gräben (G1a) sind, erzeugt werden, indem mit Hilfe einer Maske das isolierende Material und das Halbleitermaterial geätzt werden,
- bei dem aus dem isolierenden Material erste isolierende Strukturen (I1a) entstehen, die entlang zweiter Gräben (G2a) benachbarte Speicherzellen voneinander trennen.

19. Verfahren nach Anspruch 18,
- bei dem in den zweiten Gräben (G2a) Bodenstrukturen (Ba) erzeugt werden, die ebene Böden bilden, indem Material abgeschieden wird, das mindestens die zweiten Gräben (G2a) füllt, und bis zu einer Tiefe geätzt wird, die bezüglich der Achse (A) höher als die ursprünglich höchste Tiefe der zweiten Gräben (G2a) ist.

20. Verfahren nach Anspruch 18 oder 19,
- bei dem nach Erzeugung der ersten isolierenden Strukturen (I1a) auf dem zweiten Source/Drain-Gebiet (S/D2a) eine erste Hilfsschicht (H1a) aus isolierendem Material erzeugt und strukturiert wird,
- bei dem die Wortleitungen (Wla) teilweise an die erste Hilfsschicht (H1a) angrenzend gebildet werden.

21. Verfahren nach einem der Ansprüche 19 bis 20,
- bei dem nach Erzeugung der ersten isolierenden Strukturen (I1a) auf dem zweiten Source/Drain-Gebiet (S/D2a) oder auf der ersten Hilfsschicht (H1a) eine zweite Hilfsschicht (H2a) und darüber eine dritte Hilfsschicht (H3a) erzeugt werden,
- bei dem zur Erzeugung der zweiten Gräben (G2a) die zweite Hilfsschicht (H2a) und die dritte Hilfsschicht (H3a) strukturiert werden,
- bei dem die zweiten Gräben (G2a) erzeugt werden, indem Halbleitermaterial geätzt wird, wobei die dritte Hilfsschicht (H3a) als erste Maske wirkt,
- bei dem bei der Erzeugung der Bodenstrukturen (Ba) der zweiten Gräben (G2a) die zweite Hilfsschicht (H2a) als zweite Maske wirkt.

22. Verfahren nach einem der Ansprüche 13 bis 16 oder 18 bis 21,
- bei dem das erste Source/Drain-Gebiet (S/D1d) bezüglich einer Achse (A), die senkrecht zu einer Oberfläche (Od) des Substrats (1d) verläuft, oberhalb des zweiten Source/Drain-Gebiets (S/D2d) gebildet wird,
- bei dem das zweite Source/Drain-Gebiet (S/D2d) als Teil der Bitleitung (Bld) gebildet wird,
- bei dem erste isolierende Strukturen (I1d) erzeugt werden, die benachbarte Bitleitungen (Bld) voneinander elektrisch isolieren.

23. Verfahren nach den Ansprüchen 18 und 22,
- bei dem eine Schicht (SBd) für die Bitleitungen (Bld), darüber eine Schicht (SKd) für das Kanalgebiet (Kad) und darüber eine Schicht (SSd) für das erste Source/Drain-Gebiet (S/D1d) erzeugt werden,
- bei dem die ersten Gräben (G1d) so erzeugt werden, daß sie die Schicht (SBd) für die Bitleitungen (Bld) durchtrennen, wodurch die Bitleitungen (Bld) und die zweiten Source/Drain-Gebiete (S/D2d) als Teil der Bitleitungen (Bld) entstehen,
- bei dem die ersten isolierenden Strukturen (I1d), die die Bitleitungen (Bld) voneinander elektrisch isoliert, erzeugt wird, indem die ersten Gräben (G1d) mit isolierendem Material aufgefüllt werden,
- bei dem die zweiten Gräben (G2d) so erzeugt werden, daß sie ohne die Schicht (SBd) für die Bitleitungen (Bld) zu durchtrennen in diese Schicht (SBd) hineinreichen, wodurch die ersten Source/Drain-Gebiete (S/D1d), die Kanalgebiete (Kad) und als Teil der Bitleitungen (Bld) die zweiten Source/Drain-Gebiete (S/D2d) entstehen.

24. Verfahren nach einem der Ansprüche 13 bis 16 oder 18 bis 21,
- bei dem die Bitleitung (Bla) bezüglich einer Achse (A), die senkrecht zu einer Oberfläche (Oa) eines Substrats (1a), das Halbleitermaterial enthält, verläuft, unterhalb von und lateral zu dem zweiten Source/Drain-Gebiet (S/D2a) des Auswahltransistors gebildet wird,
- bei dem eine leitende Struktur (L1a) erzeugt wird, die die Bitleitung (Bla) mit dem zweiten Source/Drain-Gebiet (S/D2a) verbindet,
- bei dem das Kanalgebiet (Kaa) des Auswahltransistors über dem zweiten Source/Drain-Gebiet (S/D2a) und das erste Source/Drain-Gebiet (S/D1a) des Auswahltransistors über dem Kanalgebiet (Kaa) gebildet werden.

25. Verfahren nach den Ansprüchen 18 und 24,
- bei dem die Bitleitungen (Bla) entlang den ersten Gräben (G1a) erzeugt werden,
- bei dem die ersten isolierenden Strukturen (I1a) über den Bitleitungen (Bla) erzeugt werden.

26. Verfahren nach Anspruch 25,
- bei dem zur Erzeugung der Bitleitungen (Blb) die ersten Gräben (G1b) teilweise mit von einem zweiten Leitfähigkeitstyp dotiertem Polysilizium gefüllt werden,
- bei dem durch Tempern Dotierstoff aus dem dotierten Polysilizium in die Umgebung diffundiert, wodurch zweite Diffusionsgebiete (D2b) entstehen, die die Bitleitungen (Blb) vom Substrat (1b) trennen,
- bei dem das Substrat (1b) von einem ersten zum zweiten Leitfähigkeitstyp entgegengesetzten Leitfähigkeitstyp dotiert wird,
- bei dem angrenzend an Böden der zweiten Gräben (G2b) die zweiten Source/Drain-Gebiete (S/D2b) durch Implantation und Tempern erzeugt werden,
- bei dem die leitende Struktur erzeugt wird, indem isolierendes Material in Gebieten, in denen sich die ersten Gräben (G1b) mit den zweiten Gräben (G2b) überschneiden, entfernt wird, wodurch die Bitleitungen teilweise freigelegt werden, und durch schräge Implantation innerhalb der zweiten Gräben (G2b) erste Diffusionsgebiete erzeugt werden.

27. Verfahren nach Anspruch 25,
- bei dem zur Trennung der Bitleitungen (Blc) vom Substrat (1c) Seiten der ersten Gräben mit einer dritten isolierenden Struktur (I3c) versehen werden,
- bei dem anschließend zur Erzeugung der Bitleitungen (Blc) die ersten Gräben (G1c) teilweise mit leitendem Material gefüllt werden,
- bei dem angrenzend an Böden der zweiten Gräben (G2c) die von einem zweiten Leitfähigkeitstyp dotierten zweiten Source/Drain-Gebiete (S/D2c) durch Implantation und Tempern erzeugt werden,
- bei dem die leitenden Strukturen (L), die dotiertes Polysilizium und erste Diffusionsgebiete (D1c) umfassen, erzeugt werden, indem
a) isolierendes Material in Gebieten der zweiten Gräben (G2c), die mit den ersten Gräben (G1c) teilweise überlappen und teilweise nicht überlappen, entfernt wird, wodurch die Bitleitungen teilweise freigelegt werden,
b) das vom zweiten Leitfähigkeitstyp dotierte Polysilizium abgeschieden und rückgeätzt wird,
c) durch Tempern Dotierstoff des dotierten Polysiliziums in die Umgebung diffundiert, wodurch erste Diffusionsgebiete (D1c) erzeugt werden, die das dotierte Polysilizium vom Substrat (1c) trennen.

28. Verfahren nach Anspruch 25,
- bei dem das Substrat (1a) von einem ersten Leitfähigkeitstyp dotiert wird,
- bei dem die von einem zweiten, zum ersten Leitfähigkeitstyp entgegengesetzten Leitfähigkeitstyp dotierten Bitleitungen (Bla) angrenzend an Böden der ersten Gräben (G1a) durch Implantation und Tempern erzeugt werden,
- bei dem angrenzend an Böden der zweiten Gräben (G2a) die zweiten Source/Drain-Gebiete (S/D2a) durch Implantation und Tempern erzeugt werden,
- bei dem die leitende Struktur erzeugt wird, indem isolierendes Material in Gebieten, in denen sich die ersten Gräben (G1a) mit den zweiten Gräben (G2a) überschneiden, entfernt wird, wodurch die Bitleitungen (Bla) teilweise freigelegt werden, und durch schräge Implantation innerhalb der zweiten Gräben (G2a) erste Diffusionsgebiete (D1a) erzeugt werden.

29. Verfahren nach einem der Ansprüche 25 bis 28,
- bei dem angrenzend an Böden der zweiten Gräben (G2a) die zweiten Source/Drain-Gebiete (S/D2a) durch Implantation und Tempern erzeugt werden,
- bei dem nach Implantation der zweiten Source/Drain-Gebiete (S/D2a) und vor Erzeugung der leitenden Struktur Halbleitermaterial geätzt wird, wodurch die zweiten Gräben (G2a) teilweise tiefer werden, aber immer noch höher als die Bitleitungen (Bla) bleiben,
- bei dem nach Erzeugung der leitenden Strukturen die Bodenstrukturen (Ba) der zweiten Gräben (G2a) erzeugt werden.
